(19) Europäisches Patentamt
European Patent Office
Office européen des brevets

(11) **EP 2 051 185 A1**

(12) **EUROPEAN PATENT APPLICATION**

(43) Date of publication:
**22.04.2009 Bulletin 2009/17**

(51) Int Cl.:
*G06K 7/00* (2006.01)     *H01Q 1/00* (2006.01)
*H03J 1/00* (2006.01)     *H04B 5/00* (2006.01)

(21) Application number: **08166671.1**

(22) Date of filing: **15.10.2008**

(84) Designated Contracting States:
**AT BE BG CH CY CZ DE DK EE ES FI FR GB GR HR HU IE IS IT LI LT LU LV MC MT NL NO PL PT RO SE SI SK TR**
Designated Extension States:
**AL BA MK RS**

(30) Priority: **19.10.2007 US 875527**

(71) Applicant: **Accu-Sort System, Inc.**
**Telford PA 18969-1196 (US)**

(72) Inventor: **Hillegas, Richard**
**Slatington, PA 18080 (US)**

(74) Representative: **Gray, James**
**Withers & Rogers LLP**
**Midlands**
**Goldings House**
**2 Hays Lane**
**London SE1 2HW (GB)**

(54) **Apparatus and method for tuning a radio frequency antenna**

(57) The present invention provides a radio frequency identification tag reader system, that comprises a radio frequency identification tag reader that outputs a drive signal at a predetermined frequency at which a radio frequency tag operates, an antenna that receives the drive signal and radiates an electromagnetic field in response to the drive signal, a tuning circuit disposed between the reader and the antenna so that the drive signal passes through the tuning circuit, wherein the tuning circuit has at least one component that defines a selectable, variable electrical characteristic that selects a resonant frequency of the antenna, a sensor circuit in communication with the antenna so that the sensor circuit detects a response by the antenna to the drive signal and outputs a sensor signal that corresponds to power of an electromagnetic field radiated by the antenna in response to the drive signal, and a processor in communication with the tuning circuit so that the processor controls the selectable component, and wherein the processor receives the sensor signal and sets the variable electrical characteristic in response to the sensor signal.

FIG. 1B

**Description**

FIELD OF THE INVENTION

The present invention relates generally to radio frequency ("RF") antennas, and more particularly, to an apparatus and method for tuning an RF antenna.

BACKGROUND OF THE INVENTION

Numerous products, such as computers and other electronic devices, contain a number of smaller components that must be connected together and configured in order for the final product to be complete. In the example of computer assembly, generally at least a processor, memory, and a storage device must be attached to a motherboard for the computer to operate. Other components, such as peripherals and software, are required for the computer to properly function. Products including multiple components such as these may be handled by various people during the assembly process.

Manufacturers of such products generally require that a record documenting the workflow process of a product's assembly be maintained by the assemblers. The assemblers use the record to document all aspects of the assembly process, including the type and number of components that have been installed in the product, when and by whom each component was installed, and an indication of the remaining steps that must be taken to complete the product.

In the past, a hardcopy document was used to maintain the workflow record, where assemblers recorded information regarding the product and its components in the document during the progression of the product's assembly. This required the assemblers to pass a physical document from one assembler to the next. This could be a burdensome task depending on the number of components required to be installed, the number of installers, and the type of product. The document could easily be lost or damaged during the transfer from one assembler to the next, and so on.

Manufacturers have also used barcodes that are affixed to the product or its package to maintain the workflow record. In this case, a barcode containing information regarding the product can be attached to the product or its packaging. For example, this initial barcode may contain information about what specific components should be installed in the product and the product's final destination. A first assembler may install several components in the product and must therefore update the workflow record to reflect the installation. Due to the limitations of barcodes, however, the initial barcode itself cannot be updated with new information, including an identification of which components have recently been installed in the product, once the barcode has been printed and affixed to the product. Thus the first assembler may print a second barcode containing the updated information and affix it to the product or package, covering the initial barcode. This process is inefficient and can become tedious where it requires attachment of a new barcode to the product or its packaging each time the product is updated. Installation of multiple barcode printers may also be required if the assemblers' workstations are remotely located from one another, increasing the cost of maintaining the workflow record.

Product assembly may also involve conveyor systems to move the product throughout the manufacturing process. Although barcode scanners placed along the conveyor system could read the barcode label attached to the product or its packaging, the scanners require an uninterrupted line of sight to the barcode. A direct line of sight from the scanner to the barcode is often infeasible due to the size, shape, placement, or orientation of the product or its packaging. An added layer of control is necessary to ensure the barcode passes through the scanner's field of view at the correct orientation for the barcode to be read.

Recently, manufacturers have begun using radio frequency identification ("RFID") tags to maintain workflow records. RFID tags are relatively small and inconspicuous to the purchaser when applied to the product or its packaging. They are also capable of storing a comparatively large amount of data, which can be updated without requiring removal of the RFID tag or attachment of an additional tag. Additionally, a line of sight between an RFID tag and an antenna is not required. RFID tags are reusable and thus do not require additional printers, ink, and suitable paper, as would barcodes if new barcodes are required. An example of such an RFID tag conveyor system is described in U.S. patent application 60/773,634, which is incorporated by reference as if set forth verbatim herein.

RFID tags are designed to operate at a specific frequency or a frequency band. In order to retrieve the information stored on an RFID tag, a reader supplies the antenna with a modulated signal at the operating frequency. An antenna radiates an electromagnetic field from the modulated signal supplied by the reader that activates RFID tags located or passing through the field. The radiated signal activates the RFID tag, which replies with a responsive signal that the antenna receives and sends to the reader. The reader processes the responsive signal and may forward corresponding information to an external processor for analysis.

RF antenna systems are designed based on several factors, which, in the case of systems for reading RFID tags, includes the their intended use, operating frequency of the RFID tags with which the system is intended to operate, and the desired size of the antenna. The reader in such a system supplies a signal to the antenna at the RFID tag frequency. The system is designed so that its resonant frequency matches the desired operating frequency and so that the impedance of the antenna matches the impedance of the reader at that frequency, thereby minimizing the portion of the signal reflected by the antenna back to the reader. It is also known to configure the impedance match to achieve a desired Q at the desired operating frequency.

The resonant frequency of such antenna systems, however, can be susceptible to change created by objects located near the antennas when the systems are installed in the field. More specifically, metallic objects located near an antenna system may vary the antenna's inductance. The antenna's resonant frequency can be described by the function:

$$f = \frac{1}{2\pi\sqrt{L \times C}}$$

where f is the resonant frequency, L is the inductance of the antenna system, and C is the capacitance of the antenna system. Thus, the change in inductance shifts the antenna's resonant frequency. If the shift is sufficient to impede the antenna's ability to communicate with RFID tags at the tags' operating frequency under the conditions for which the system is intended to operate, the antenna may be considered to have become detuned.

It is known to retune such a system by using a network analyzer or a standing wave ratio ("SWR") meter in order to measure the power loss of the supplied signal. For example, a network analyzer is attached to the antenna, to which the analyzer supplies a signal at the desired operating frequency. The meter measures how much of the signal is reflected by the antenna, thereby indicating whether the resonant frequency and the impedance of the antenna acceptably match the desired operating frequency and the source impedance, respectively. A variable capacitor contained in the antenna system is manually adjusted, and this procedure is repeated until the user believes the antenna is tuned fat or near the desired operating frequency.

SUMMARY OF THE INVENTION

The present invention recognizes and addresses the foregoing considerations, and others, of prior art construction and methods.

In this regard, the present invention provides a radio frequency identification tag reader system that comprises a radio frequency identification tag reader that outputs a drive signal at a predetermined frequency at which a radio frequency tag operates, an antenna that receives the drive signal and radiates an electromagnetic field in response to the drive signal, a tuning circuit disposed between the reader and the antenna so that the drive signal passes through the tuning circuit, wherein the tuning circuit has at least one component that defines a selectable, variable electrical characteristic that selects a resonant frequency of the antenna, a sensor circuit in communication with the antenna so that the sensor circuit detects a response by the antenna to the drive signal and outputs a sensor signal that corresponds to power of an electromagnetic field radiated by the antenna in response to the drive signal, and a processor in communication with the tuning circuit so that the processor controls the selectable component, and wherein the processor receives the sensor signal and sets the variable electrical characteristic in response to the sensor signal.

Another embodiment of the present invention provides an antenna system that comprises an antenna that radiates an electromagnetic field in response to a drive signal, a tuning circuit connected to the antenna through which the drive signal passes, wherein the tuning circuit has at least one component that defines a selectable, variable resonant frequency of the antenna, a sensor circuit in communication with the antenna so that the sensor circuit receives a response signal corresponding to the electromagnetic field and outputs a sensor signal that corresponds to the response signal, and a processor in communication with the tuning circuit so that the processor controls the selectable component, and wherein the processor receives the sensor signal and sets the variable resonant frequency through the selectable component in response to the sensor signal.

A further embodiment of the present invention provides a method for tuning an antenna system comprising the steps of applying a drive signal to an antenna through a tuning circuit, wherein the tuning circuit has at least one component that defines a selectable, variable resonant frequency of the antenna, receiving a first response signal corresponding to a first electromagnetic field radiated by the antenna in response to a first setting of the variable resonant frequency, varying the variable resonant frequency to a second setting, repeating these steps, where each of the second settings is the first setting of the subsequent repetition, and electronically selecting a first response signal from among a plurality of first response signals received according to a predetermined criteria and electronically selecting the first setting of the variable resonant frequency at which the selected first response signal was received.

According to another embodiment, the present invention also provides a method for tuning an antenna system comprising the steps of applying a drive signal to an antenna through a tuning circuit, wherein the tuning circuit has at least one component that defines a selectable, variable electrical characteristic that selects a resonant frequency of the antenna, receiving a first response signal corresponding to a first electromagnetic field radiated by the antenna in response to a first setting of the variable electrical characteristic, varying the variable electrical characteristic to a second setting by a predetermined increment, repeating these steps for a range of predefined values for the variable electrical characteristic, wherein each of the second settings is the first setting of a subsequent repetition, selecting a first response signal from among a plurality of first response signals received according to a predetermined criteria, and selecting the first setting of the variable electrical characteristic at which the selected first response signal was received.

In another embodiment, the present invention also provides a method of tuning a radio frequency identification tag reader system having a radio frequency identification tag reader that outputs a drive signal at a predetermined frequency at which a radio frequency tag operates, an antenna that receives the drive signal and radiates an electromagnetic field in response to the drive signal, and a tuning circuit disposed between the reader and the antenna so that the drive signal passes through the tuning circuit, wherein the tuning circuit has at least one component that defines a selectable, variable capacitance between the reader and the antenna, comprising detecting a response by the antenna to the drive signal at a selected setting of the variable capacitance, measuring power of the response and generating a signal corresponding to the power, altering the setting of the variable capacitance, repeating these steps over a range of settings of the variable capacitance, electronically comparing the signals corresponding to the power at the settings over the range of settings of the variable capacitance, electronically selecting the setting at which a highest power occurs, and electronically adjusting the selectable, variable capacitance to the selected setting.

The accompanying drawings, which are incorporated in and constitute a part of this specification, illustrate one or more embodiments of the invention and, together with the description, serve to explain the principles of the invention.

BRIEF DESCRIPTION OF THE DRAWINGS

A full and enabling disclosure of the present invention, including the best mode thereof directed to one of ordinary skill in the art, is set forth in the specification, which makes reference to the appended drawings, in which:

Figure 1A is a schematic representation of a conventional antenna system;
Figure 1B is a schematic representation of a tapped C transformer within an antenna system;
Figure 2 is a graphical representation of the return loss characteristic of an exemplary antenna system;
Figure 3 is a graphical representation of the return loss characteristic of an exemplary antenna system;
Figure 4 is a graphical representation of the return loss characteristic of an exemplary detuned antenna system;
Figure 5 is a schematic representation of an antenna system in accordance with an embodiment of the present invention;
Figure 6 is a schematic representation of an exemplary sampling circuit and signal detecting and averaging circuitry of the antenna system of Figure 5 in accordance with an embodiment of the present invention;
Figure 7A is a schematic representation of a matching and frequency tuning circuit and antenna of the antenna system of Figure 5 in accordance with an embodiment of the present invention;
Figure 7B is a simplified schematic representation of the tuning circuit and antenna of Figure 7A in accordance with an embodiment of the present invention;
Figures 8 through 12 are process flowcharts of an exemplary algorithm used in combination with the antenna system of Figure 5 in accordance with an embodiment of the present invention;
Figure 13 is a graphical representation of the radiated power produced by the antenna system of Figure 5 measured by the process set forth in the algorithm of Figures 8 through 12 in accordance with an embodiment of the present invention;
Figure 14 is a schematic representation of an exemplary sampling circuit of the antenna system of Figure 5 in accordance with an embodiment of the present invention;
Figure 15 is a schematic representation of an exemplary sampling circuit of the antenna system of Figure 5 in accordance with an embodiment of the present invention;
Figure 16 is a schematic representation of an exemplary signal detecting and averaging circuitry of the antenna system of Figure 5 in accordance with an embodiment of the present invention; and
Figure 17 is a schematic representation of an optional buffer circuit in accordance with an embodiment of the present invention.

Repeat use of reference characters in the present specification and drawings is intended to represent same or analogous features or elements of the invention.

DETAILED DESCRIPTION OF PREFERRED EMBODIMENTS

Reference will now be made in detail to presently preferred embodiments of the invention, one or more examples of which are illustrated in the accompanying drawings. Each example is provided by way of explanation of the invention, not limitation of the invention. In fact, it will be apparent to those skilled in the art that modifications and variations can be made in the present invention without departing from the scope or spirit thereof. For instance, features illustrated or described as part of one embodiment may be used on another embodiment to yield a still further embodiment. Thus, it is intended that the present invention covers such modifications and variations as come within the scope of the appended claims and their equivalents.

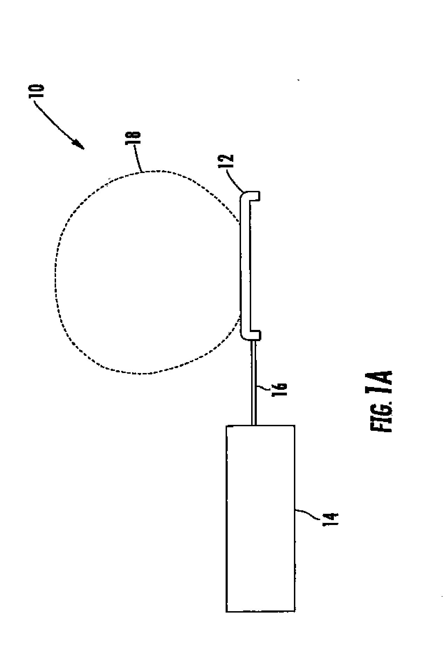

Figure 1A illustrates a conventional antenna system 10 comprising an antenna 12 connected to a reader 14 via a feed line 16. In operation, reader 14 provides antenna 12 with a modulated radio frequency signal via feed line 16, referred to as the "drive signal," at a carrier frequency corresponding to the frequency at which the relevant RFID tags operate, referred to herein as the "operating frequency." In response to the drive signal, antenna 12 emits an electromagnetic field in which the RFID tags are read. In the presently described embodiment, the antenna system is designed and operated so that the antenna radiates an electromagnetic field over such a distance and at such a power level that the near field component of the electromagnetic field extends over an area in which the RFID tags are expected (denoted by dashed object 18), such that the field's near field component excites such tags and the antenna system can readably receive the tag responses. The near field component may be referred to as the magnetic field radiated by antenna 12 in response to the drive signal supplied by reader 14, up to a distance of about

$$\frac{\lambda}{2\pi}$$

where $\lambda$ is the wavelength of the radiated signal. As used herein, the term "electromagnetic field" may refer to an electric field, a magnetic field, or a combination of the two.

Reader 14 generally includes a transmitter, a receiver, and a microprocessor, which controls the transmitter and the receiver or transceiver. The reader may communicate with an external computer via a connection line. The microprocessor sends a bit sequence to the transmitter, which then transmits the signal at a specified frequency and power level to antenna 12. Antenna 12 returns a detected signal from an RFID tag to the receiver via the antenna's feed line. The receiver removes the carrier signal and sends the resulting information signal to the microprocessor, which may then transmit digital data to the external computer for analysis or further processing. RFID engines suitable for use in the presently disclosed system are available from AWID Wireless Informations, Inc. of Monsey, New York; Symbol Technologies, Inc. of San Jose, California (e.g. the Matrics AR400); and ThingMagic of Cambridge, Massachusetts (e.g. the MERCURY 4).

Antenna system 10 is generally designed for desired characteristics. For instance, the size of antenna 12 may be selected to achieve a read zone of a desired size. Once designed, the inductance of the antenna can be determined according to known formulas. Inductance formulas depend upon the configuration of the inductor, but, in general, rely upon free space permeability, the relative permeability of the material forming the inductor, and the inductors dimensions.

Antenna system 10 is also designed so that its resonant frequency matches the desired operating frequency at which the relevant RFID tags operate. The resonant frequency of antenna system 10 can be determined by the formula:

$$f = \frac{1}{2\pi\sqrt{L \times C}}$$

where f is the resonant frequency, L is the inductance of antenna system 10, and C is the capacitance of the antenna system. Therefore, the capacitance, or C, required by antenna system 10 to establish a resonant frequency at the RF tags' desired operating frequency can be determined by substituting the operating frequency for *f* above.

Additionally, antenna system 10 is designed so that the impedance of antenna 12 matches the impedance of reader 14 at the desired frequency and so that the system exhibits a loaded Q within a desired range. As should be understood in this art, loaded Q describes the passband characteristics of a circuit under actual loaded conditions. Generally, as Q increases, the power of the radiated electromagnetic field at the resonant frequency increases. If the loaded Q is too high, the antenna system's bandwidth may become too narrow, thereby inhibiting communication between the system and RFID tags and increasing the probability that a shift in the antenna's resonant frequency caused by the environment will detune the antenna. Thus, a narrow bandwidth increases the likelihood that the antenna system will not acceptably function if the resonant frequency shifts even slightly from the operating frequency.

Bandwidth improves as Q decreases, but the power of the antenna's radiated magnetic field at the resonant frequency also decreases, thereby reducing the antenna's effective read range. Accordingly, the system may be configured to a desired Q that provides sufficient operative bandwidth to communicate with the RFID tag and that provides an acceptable read range at the resonant frequency. That is, a desirable loaded Q may be selected based on the power output and bandwidth needed for operation of the system depending on its intended use. Generally, a loaded Q within the range of 10 to 50 is adequate for antenna system 10 of the present embodiment, although it should be understood that other values for loaded Q may be chosen depending on the configuration and use of the system.

The loaded Q is primarily defined by three factors: source impedance, load impedance, and "component Q." Component Q is the reactance compared to the resistance of each component contained in the circuit. Certain components, such as the capacitors and inductor used in the current embodiment, exhibit a significantly high component Q, which have a minimal effect on loaded Q and are thus ignored in the discussion of loaded Q for purposes of explanation.

Loaded Q may be determined according to the formula:

$$Q = \frac{R_P}{X_P}$$

where Rp is the equivalent parallel resistance of the source resistance ("$R_s$") and the load resistance ("$R_L$"), and $X_P$ is either the capacitive reactance ("$X_C$") or the inductive reactance ("$X_L$") of antenna system 10. As should be well understood in this art, impedance includes both resistance and reactance, and a process for impedance matching may therefore include matching both the resistance and reactance of the source to the resistance and reactance of the load. Therefore, the source and load resistances of antenna system 10, as well as its capacitive reactance and inductive reactance at the desired frequency, should be equal at resonance in a matched system. Thus, $X_C$ is equal to $X_L$, and $R_S$ (after matching) is equal to $R_L$, when the impedances of antenna 12 and reader 14 are matched at the desired frequency. $X_L$ can be determined for a given frequency (here, the operating frequency) by the formula $X_L = 2\pi \times f \times L$, where f is the operating frequency and L is the inductance of antenna 12. Based on a desired loaded Q and the inductive reactance, the source and load resistances can be determined according to the following formula since they are also equal in a matched system:

$$R_P = \frac{R_S + R_L}{R_S \times R_L}$$

While antenna 12 in this example is a one inch trace loop, rendering its resistance negligible, the antenna's resistance could otherwise be determined according to the formula:

$$R_{AC} = \frac{2.61 \times 10^{-7} \times \sqrt{f \times P_R}}{2 \times (w + h)}$$

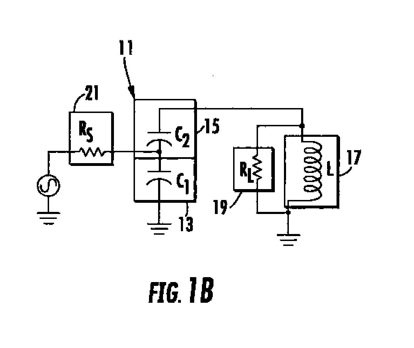

where $R_{Ac}$ is the AC resistance of the trace used to form the loop antenna at the operating frequency f, $P_R$ is the trace resistivity (based on copper in this example), w is the width of the trace, and h is the height of the trace. However, as the resistance of antenna 12 is negligible, the load resistance $R_L$ can be defined simply by adding a resistor 19 across the antenna, as indicated in Figure 1B.

As noted above, $R_L$ must equal $R_S$ in a matched system. $R_P$ is defined by the loaded Q (which is selected by the system designer) and $X_P$ (which is defined by the antenna inductive and the resonant frequency). These two relationships thereby define $R_L$ (*i.e.,* the value of resistor 19) and the desired $R_S$.

$R_S$ 21 is the resistance associated with reader 14 (Figure 1). In order to match $R_S$ to the value of $R_L$ defined as described above, while providing the capacitance C needed to match the resonant frequency to the desired operating frequency as described above, the present embodiment includes a tapped C transformer 11 comprising two capacitances 13 ("$C_1$") and 15 ("$C_2$"). The value of capacitances $C_1$ and $C_2$ are related according to the formulas:

$$\frac{C_1}{C_2} = \sqrt{\frac{R_S{'}}{R_S}} - 1 \qquad \text{and} \qquad C = \frac{C_1 \times C_2}{C_1 + C_2} \text{ or } \qquad \frac{1}{C} = \frac{1}{C_1} + \frac{1}{C_2}$$

where $R_S{'}$ is the desired source resistance required to match $R_L$, and C is the capacitance required by antenna system 10 to establish a resonant frequency at the desired operating frequency. Because the values for $R_S{'}$, $R_S$, and C are known, or can be determined as described above, $C_1$ and $C_2$ can be determined from these two relationships. Accordingly, tapped C transformer 11 provides the capacitance necessary to match the resonant frequency to the desired operating frequency, while matching the impedance of antenna 12 (Figure 1) to the impedance of reader 14, and achieving a desirable loaded Q.

Referring again to Figure 1A, the portion of the drive signal reflected by antenna 12 is referred to as "return loss" and is measured as a ratio (in "dB") of the amount of power reflected by the antenna compared to the amount of power supplied by reader 14. For example, a return loss of - 20dB indicates that a hundredth of the signal's power supplied by reader 14 is reflected by antenna 12 to the reader. A return loss of -30dB indicates that a thousandth of the signal's power is reflected. For the purposes of this example, a preferred antenna system exhibits a return loss of equal or less than approximately -20dB at the desired frequency, preferably at a desired loaded Q.

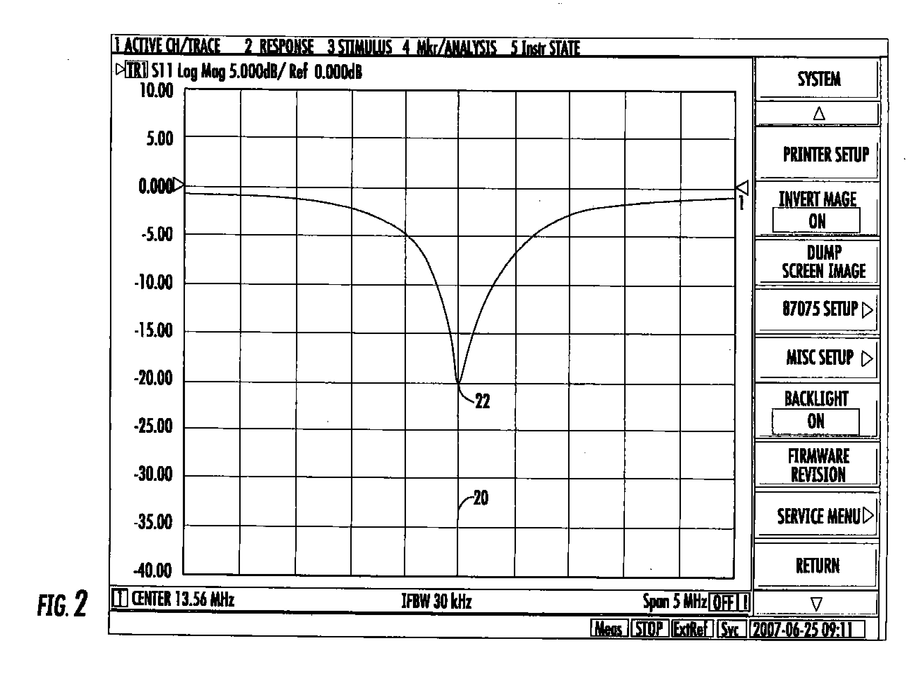

Figure 2 is a graphical representation of the return loss characteristic of an exemplary antenna system where the operating frequency is 13.56 MHz. A network analyzer or an SWR meter described above are examples of devices that are capable of measuring an antenna's return loss characteristic and may be used to create a graphical representation of the loss characteristic, such as the illustration shown in Figure 2. The use of these devices should be understood by those skilled in the art. Referring to Figure 2, the center line (denoted at 20) has been set to correspond to the operating frequency at which the associated RFID tags operate; that is, 13.56 MHz in the present embodiment. Accordingly, Figure 2 indicates that the corresponding antenna system exhibits a return loss of -20dB at the optimum resonant frequency (denoted at point 22), which is matched to the operating frequency of 13.56 MHz. Of course, it should be understood that what is acceptable for a given system depends on the use of the system.

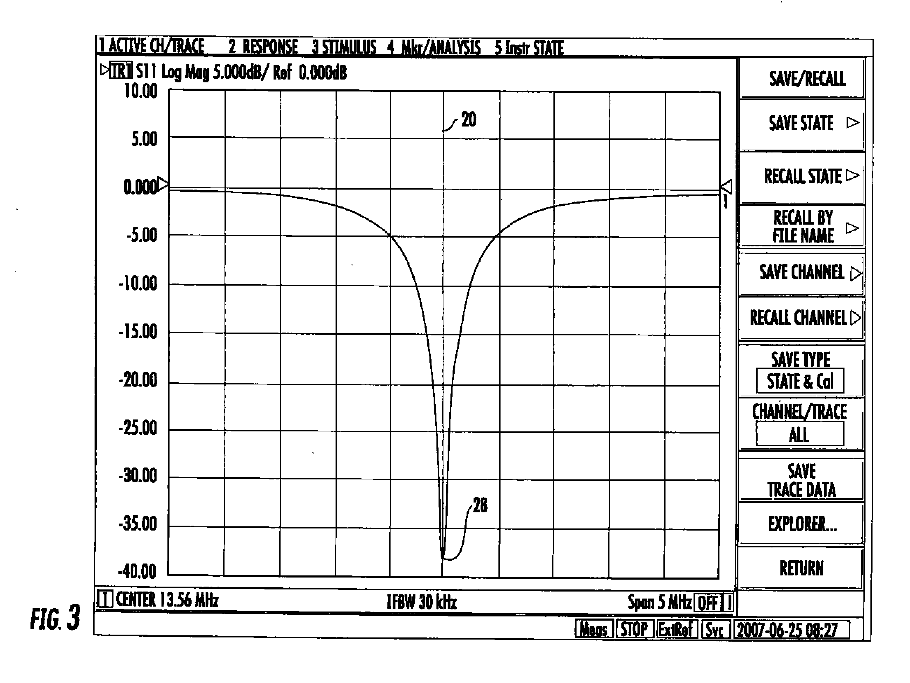

Figure 3 is a graphical representation of the return loss characteristic of the same antenna system, where both the resonant frequency more closely matches the operating frequency and the impedance matching at that frequency has been improved over the matching shown in Figure 2 so that the return loss is decreased. Thus, the antenna system represented by Figure 3 exhibits a return loss of less than -30dB at the desired operating frequency. The antenna system associated with Figure 3 exhibits a smaller return loss at the optimum resonant frequency than that of the antenna system corresponding to Figure 2.

Referring again to Figures 1A and 1B, the environment in which antenna 12 is placed, for example temperature, humidity, and proximate metal objects, may cause the resonant frequency of antenna 12 to deviate from the desired operating frequency and the impedance match at the resonant frequency to degrade. As a result, a substantially larger percentage of the signal applied to antenna 12 at the operating frequency is reflected to reader 14, negatively affecting the read range of antenna system 10.

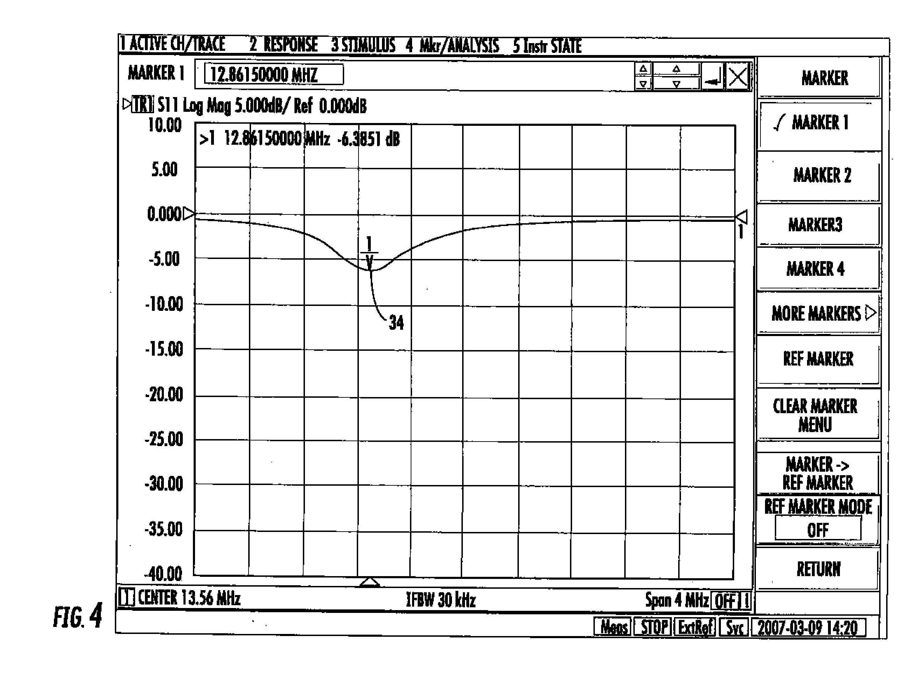

Figure 4 is a graphical representation of the return loss characteristic of the antenna system represented by Figures 2 and 3 that has become detuned in the shift in resonant frequency, e.g., by the antenna's environment. Figure 4 illustrates that the associated antenna's optimum resonant frequency has shifted to approximately 12.86MHz (denoted at point 34). Figure 4 also indicates that the return loss of a signal applied to the antenna at the desired operating frequency (13.56 MHz in this case) is much greater (-2bB) than the return loss of the same signal applied to the same antenna that has not been detuned (as illustrated by Figures 2 and 3). As a result, the corresponding detuned antenna radiates a magnetic field at the desired operating frequency exhibiting a power level substantially lower than would the same antenna that has not been detuned. Depending on the use of the antenna, this power level may be inadequate to send and receive signals to nearby RFID tags configured to operate at the desired frequency.

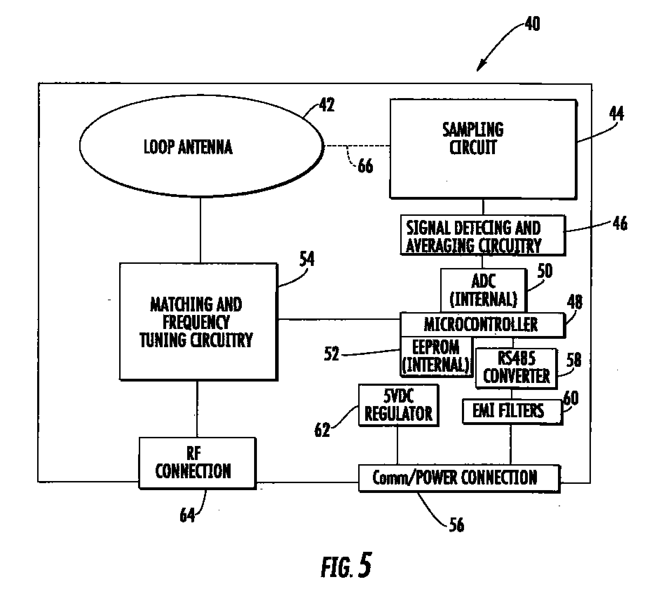

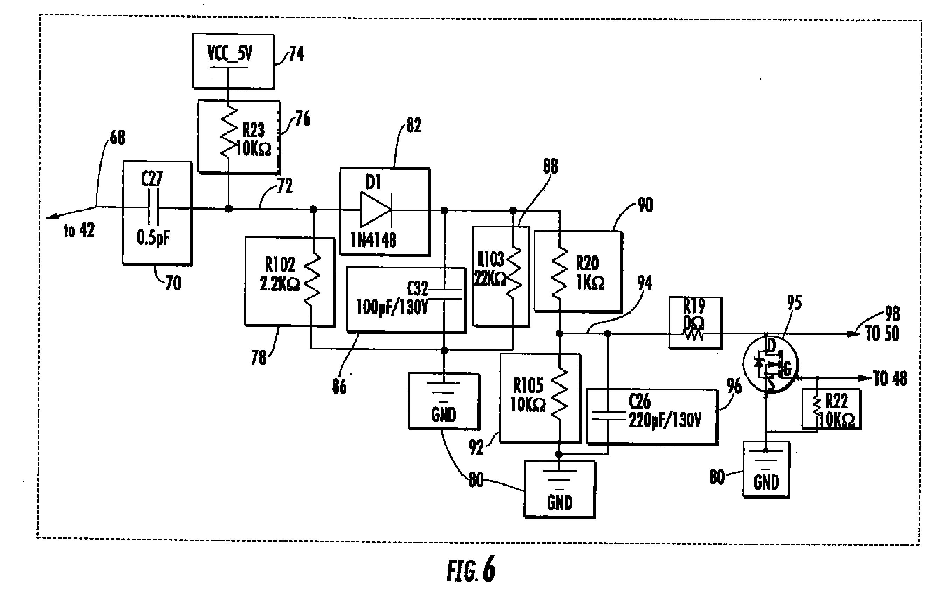

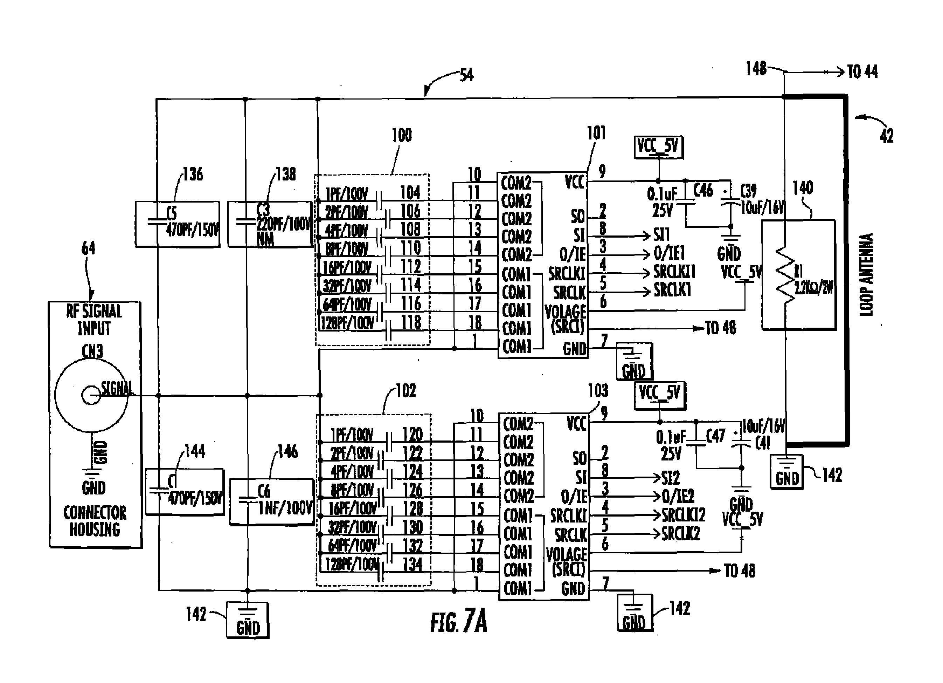

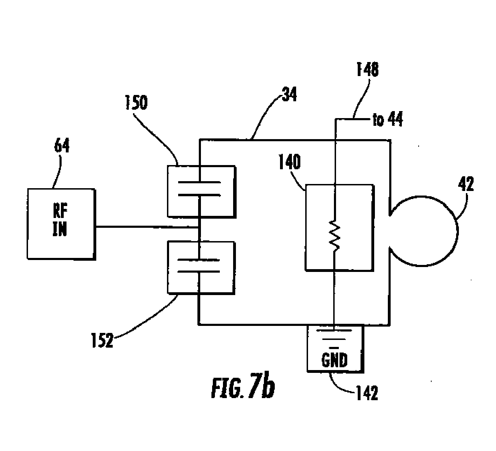

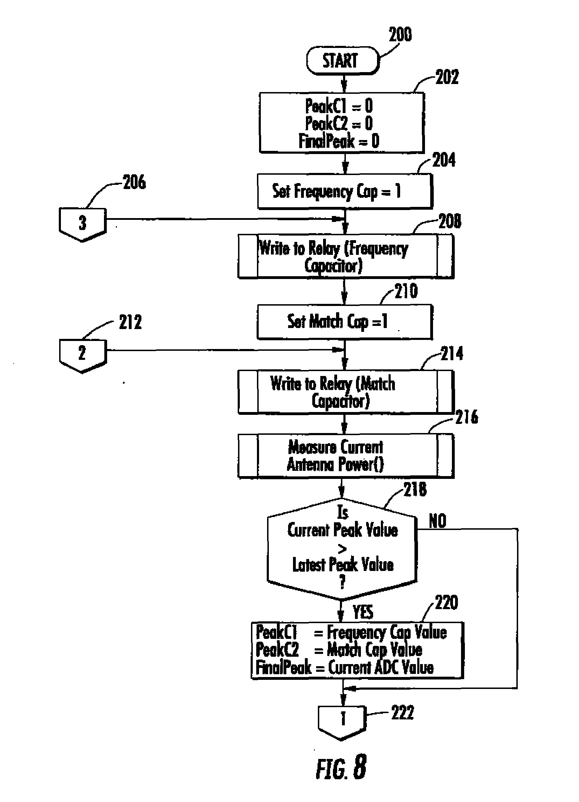

In this situation, it is desirable to tune antenna system 10 so that the resonant and operating frequencies match. In the presently described embodiment, this is accomplished by changing capacitance C through the use of tapped C transformer 11. In one exemplary embodiment, adjustment of tapped C transformer 11 also reestablishes the impedance match. A preferred embodiment of the method and system for tuning an antenna system is described with respect to Figure 5. This broad description is followed by a detailed description of the operation and construction of the various components of the system with respect to Figures 6, 7A, and 7B. The algorithm executed by the system in one embodiment is described in detail with respect to Figures 8 through 12.

Figure 5 illustrates an antenna system 40 having a loop antenna 42 coupled to a sampling circuit 44, which is connected to a signal detecting and averaging circuitry ("SDAC") 46. SDAC 46 is operatively connected to a microcontroller 48, which includes an analog-to-digital converter ("ADC") 50 and a memory 52. Microcontroller 48 is connected to an impedance matching and frequency tuning circuitry ("tuning circuitry") 54 and to the communication and power connection 56 of an antenna reader via an RS485 converter 58 and multiple electromagnetic interference ("EMI") filters 60. A voltage source regulator 62 is also connected to connection 56. An RF connection 64 of the reader is connected to antenna 42 via tuning circuitry 54.

In operation, the reader supplies a drive signal to antenna 42 via RF connection 64 and tuning circuitry 54. Regulator 62 supplies a stable supply of power (5VDC) from power connection 56 to antenna system 40 sufficient for the system's circuitry to operate. The drive signal is provided through the circuitry of tuning circuitry 54 to antenna 42 as described in more detail below with respect to Figures 7A and 7B. In response to the drive signal, the antenna emits an electromagnetic field, the near field of which excites RFID tags passing through the field. The tags respond to the signal from the antenna, radiating a return signal that is received by the antenna so that a corresponding signal is returned to the reader through tuning circuitry 54 and RF connection 64. In the presently described embodiment, the RFID tags operate at a predefined frequency, and the reader therefore drives the antenna to radiate query signals at that frequency, and the system is tuned at the factory so that the system's resonant frequency coincides with this desired frequency. As described above, however, the environment in which antenna 42 has been placed may cause the antenna's resonant frequency to shift. This shift in resonant frequency caused by the environment proximate antenna 42 affects the antenna's read range at the desired frequency, as indicated by comparison of Figures 2 and 3 to Figure 4. Accordingly, microcontroller 48 selectively adjusts tuning circuitry 54 to thereby tune antenna 42 so that the resonant frequency shifts counter to the shift caused by the environment so that the resonant frequency again encompasses the operating frequency. The algorithm by which the microcontroller adjusts tuning circuitry 54 is described in detail below with respect to Figures 7A through 12. Depression of a button (not shown) connected to the reader sends a signal to the reader microprocessor indicating that retuning is desired. The reader outputs a corresponding signal via connection 56 of Figure 5 to microcontroller 48, which responsively begins the tuning process. In another embodiment, a graphical user interface ("GUI") located on a computer connected to the reader's microprocessor instructs microcontroller 48 through connection 56 of the reader and RS485 converter 58 to begin the tuning process.

Still referring to Figure 5, sampling circuit 44 and SDAC 46 comprise a sensor circuit in communication with antenna 42 that detects a response by the antenna to the drive signal and outputs a signal to microcontroller 48 corresponding to the power of the magnetic field radiated by the antenna in response to the drive signal. Sampling circuit 44 is coupled to antenna 42, as indicated at 66, by an electrical connection suitable to provide a signal to sampling circuit 44 representative of the power level of the magnetic field the antenna radiates in response to the drive signal received from reader 14 (Figure 1). Coupling 66 may be effected by any suitable means, for example a capacitive or inductive coupling or through a jumper wire that directly connects the electrical current in the antenna to the sampling circuit - that is, the energy radiated by the loop antenna may be sampled by measuring the magnetic field radiated by the antenna or measuring the electric current or voltage present on the antenna itself. As should be understood in this art, the method by which sampling circuit 44 acquires the representative power signal from loop antenna 42 will affect the construction and operation of sampling circuit 44. Thus, while the sampling circuit discussed below with respect to Figure 6 is based on an embodiment in which the antenna's electrical current is tapped directly to the sampling circuit, it should be understood that this description is for purposes of explanation only and that any suitable sampling circuit may be employed. In the example shown in Figure 5, sampling circuit 44 acquires an alternating current ("AC") signal from the antenna and provides the signal to SDAC 46, which converts the signal to a direct current ("DC") signal and provides the DC signal to the microcontroller's ADC 50. Thus, sampling circuit 44 and the SDAC 46 detect a response by the antenna to the drive signal of the reader supplied to the antenna from RF connection 64 and output a DC signal to ADC 50 representative of power of the magnetic field radiated by the antenna.

ADC 50 of microcontroller 48 is a ten bit analog-to-digital converter having a 4.88 millivolt ("mV") resolution. That is, each ten bit binary number corresponds to a numerical value between 0 and 1024 and equates to a 4.88mV change in voltage of the signal received from SDAC 46. The reference voltage of ADC 50 is set to 5V, and any DC signal received from SDAC 46 exhibiting a voltage equal to or greater than 5V is associated with the maximum ten bit binary number, *i.e.*, a value of 1024. DC voltages less than 5V correspond to numbers less than 1024, defined in 4.88mV increments, down to a floor value of 0 corresponding to 2.88 mV. For instance, a 4.99512 volt DC signal corresponds to the number 1023; a 4.99024 volt DC signal corresponds to the number 1022, and so on. In this manner, ADC 50 converts the analog voltage level of the DC signal received from SDAC 46 to a digital signal defined in numeric values. For every setting of tuning circuitry 54 (described below), microcontroller 48 acquires such a digital value respectively corresponding to twenty samples of the DC output of SDAC 46, averages the twenty values, and stores in memory 52 the average in association with the given setting of tuning circuitry 54, if it is higher than the previously stored value. Although the microcontroller obtains twenty samples in the present embodiment, it should be understood that fewer or more samples may be taken. For instance, while a greater number of samples improves reliability, an increased number of samples incurs a time expense. After acquiring the samples, determining the average and storing the average with the setting of tuning circuitry 54 that resulted in the average, microcontroller 48 instructs tuning 54 to increment its setting, according to the algorithm described below.

The procedure repeats until microcontroller 48 completes the steps of the below sampling algorithm. Through this procedure, microcontroller 48 selects the highest power level value, identifies the settings of tuning circuitry 54 that correspond to the optimized value, and instructs the tuning circuitry to configure to these settings. As described below, the tuning circuitry settings match the resonant frequency to the desired frequency and, in certain embodiments, the impedance of antenna 42 to reader 14 at the desired frequency. As a result, the return loss of the signal supplied by the reader to antenna 42 is minimized at the frequency at which the system communicates with RFID tags, resulting in transmission of an RF signal at a maximum power level at the desired frequency. As described below, the loaded Q is generally affected only negligibly, and thus should remain within an acceptable level.

Figure 6 illustrates an exemplary envelope detector circuit that encompasses sampling circuit 44 and SDAC 46 (Figure 5) in accordance with an embodiment of the present invention. Sampling circuit 44 is connected by a jumper wire (indicated at 68) to antenna 42 so that an AC electrical current is tapped from the antenna to a capacitor 70. Capacitor 70 outputs through a trace 72 to a diode 82, to which a forward bias is applied by a 5 volt source 74 through a resistor 76. A resistor 78 is connected to ground 80 from a point between capacitor 70 and diode 82. A capacitor 86, resistor 88, and a series combination of resistors 90 and 92 are connected in parallel between the output of diode 82 and ground 80. Capacitor 96 provides additional AC filtering to the signal at 94, which is a DC voltage, before the signal is output to a field effect transistor ("FET") 95, which discharges capacitor 96 before the twenty samples are taken for each new setting of tuning frequency circuitry 54. The output 98 of SDAC 46 (Figure 5) is directed to ADC 50 (Figure 5).

In the present example, a capacitor having a small capacitance (e.g., less than 1 picofarad ["pF"], and in this instance, 0.5pF) is selected for capacitor 70 to reduce the load the envelope detector places on antenna 42, as well as to reduce a portion of the signal tapped from the antenna. Resistors 76 and 78 are chosen to step the voltage of voltage source 74 down to a point just above the turn-on level of diode 82. Thus, diode 82 passes the positive portion of the AC signal tapped from jumper 68 though capacitor 70 but blocks approximately all of the signal's negative portion so that diode 82 half-wave-rectifies the input signal. The input signal's positive half wave portion charges capacitor 86, which discharges during the input signal's negative half cycle, thereby smoothing the output signal at 94. The rate at which capacitor 86 discharges is determined by the capacitance of capacitor 86 and the resistance of the parallel combination of resistor 88 and resistors 90 and 92. Since the time required to discharge capacitor 86, and therefore to acquire a valid sample of the input signal, is directly related to this RC time constant, the values of capacitor 86 and resistor 88 are preferably chosen so that the circuit can acquire a sample of the input signal within an acceptable period of time. On the other hand, if the RC time constant is too short, capacitor 86 may discharge so quickly that the capacitor's smoothing function is inhibited and the likelihood of measurement errors increased. Accordingly, the values of capacitor 86 and resistor 88 are preferably chosen to achieve a time constant that results in an acceptably short measurement period with a reliable signal, as measured against the desired performance for a given system. Resistors 90 and 92 are chosen to reduce the signal voltage across resistor 88 at output point 94 to a magnitude within the input range of microcontroller analog-to-digital converter 50 (Figure 5).

Figure 7A illustrates tuning circuitry 54, in this instance a tapped C transformer (see 11 at Figure 1B), connected between antenna 42 and the RF connection 64 (Figure 5) of the reader in accordance with an embodiment of the present invention. Antenna 42 is also connected to ground 142. In this example, tuning circuitry 54 is a tapped "C" transformer comprising two capacitor banks 100 and 102, each having eight capacitors, 104-118 and 120-134, respectively, connected in parallel. It should be understood, however, that the tapped C transformer is described herein for purposes of illustration only, and that other suitable tuning circuits having capacitance or inductance that is variable to adjust the antenna's resonant frequency to a desired frequency may be utilized.

The values for capacitors 104, 106, 108, 110, 112, 114, 116, 118, 120, 122, 124, 126,128, 130, 132, and 134 are 1, 2, 4, 8, 16, 32, 64, 128, 1, 2, 4, 8, 16, 32, 64, and 128 pF, respectively. Banks 100 and 102 are connected to separate eight-switch relays 101 and 103, respectively, such that each switch within the relays is associated with a respective capacitor in its capacitor bank. Microcontroller 48 is connected to relays 101 and 103 via a four-wire interface. Each relay includes a shift register that controls which switches of the relays are open or closed based on a value written to the register.

The capacitors in each bank are connected in parallel as to the output of the relay set. Thus, the total capacitance for each bank is the sum of the values of the capacitors in the bank for which the associated relay switches have been closed by microcontroller 48. That is, microcontroller 48 selects the capacitance of each of banks 100 and 102 by selectively connecting the parallel capacitors in the bank between the input and output of the bank, by way of switches within relays 101 and 103 according to the algorithm as described below. Thus, each of capacitor banks 100 and 102 may be considered a variable capacitor.

Variable capacitor bank 100 is connected to capacitors 136 and 138 in parallel between RF connection 64 and antenna 42. Because variable capacitor bank 100, capacitor, 136, and capacitor 138 are connected in parallel, the total value of capacitance for the three is the sum of the capacitance values of the capacitor bank and capacitors 136 and 138. This capacitance, which corresponds to capacitance $C_2$ in Figure 1B, has a greater impact on the resonant frequency adjustment to antenna 42 than does capacitance $C_1$ (Figure 1B), due to the relatively small capacitance of $C_2$ as opposed to $C_1$, and is referred to herein as the "frequency capacitance." Similar to bank 100, variable capacitor bank 102 is connected to capacitors 144 and 146 in parallel between RF connection 64 and ground 142. Because variable capacitor bank 102, capacitor 144, and capacitor 146 are connected in parallel, the total value of capacitance for the three is the sum of the capacitance values of the capacitor bank and capacitors 144 and 146. This capacitance, which corresponds to capacitance $C_1$ in Figure 1B, has a greater impact on the impedance match adjustment between antenna 42 and the RF reader and is referred to herein as the "impedance capacitance." As noted above, resistor 140 is connected across antenna 42 to achieve a desirable loaded Q. An RF feedback line 148 indicates where connection line 68 (Figure 6) of sampling circuit 44 is attached to tuning circuitry 54. Tuning circuitry 54 includes additional internal components as set forth in Figure 7A, the construction and operation of which should be apparent to those of ordinary skill in the art.

Figure 7B is a simplified schematic representation of tuning circuitry 54, RF connection 64, and antenna 42. Frequency capacitance 150 ("$C_{FT}$") comprises variable capacitor bank 100 and capacitors 136 and 138 (Figure 7A) and corresponds to $C_2$ of Figure 1B. Impedance capacitance 152 ("$C_{MT}$") comprises variable capacitor bank 102 and capacitors 144 and 146 (Figure 7A) and corresponds to $C_1$ of Figure 1B. As set forth above, these capacitances have an effect on the capacitance C of antenna system 40 and its resonant frequency according to the formulas:

$$ f \ = \ \frac{1}{2\pi \sqrt{L \times C}} \qquad \text{and} \qquad C \ = \ \frac{1}{\dfrac{1}{C_{FT}} + \dfrac{1}{C_{MT}}} $$

As the values of these capacitances increase such that the sum of their inverse terms decrease, the resonant frequency decreases, and likewise, as the values decrease such that the sum of their inverse terms increase, the resonant frequency increases according to the above formula. In a given type of environment, the degree to which the antenna is likely to shift in resonant frequency and degrade in impedance match tends to fall within a range that can be determined through experiment and/or experience. Thus, the total capacitance of the selectable capacitors in banks 100 and 102 is preferably sufficient to move the resonant frequency and impedance match at least across the width of such an expected range. Moreover, the capacitances of the capacitors within the capacitor banks are small in the presently described embodiment, to thereby allow relatively fine adjustments in re-tuning the antenna. It should be understood that the values of the capacitors in banks 100 and 102, as well as capacitors 136, 138, 144, and 146, may be altered depending on the configuration of antenna system 40, the desired resonant frequency, and the variation in the resonant frequency expected or experienced by the working environment. For example, capacitor 138 may be omitted in another embodiment to account for the expected shift in the resonant frequency of antenna system 40 caused by the working environment, depending on the expected shift and desired operating frequency.

Detuning may raise or lower the antenna's resonant frequency depending on the environment. In the arrangement shown in Figure 7A, the selection/activation of capacitance in bank 100 by microcontroller 48 increases the capacitance C of antenna system 40, thereby lowering the antenna's optimum resonant frequency. That is, beginning at a condition of zero activated capacitance in bank 100, selective incremental activation of capacitance in bank 100 incrementally lowers the antenna's resonant frequency. Because capacitor bank 100 shifts the resonant frequency lower, fixed capacitors 136 and 138 are chosen (in the present embodiment, 470pF and 220pF, respectively) so that with all of the capacitors of bank 100 disconnected, the antenna's initial resonant frequency is above the desired resonant frequency by an amount that, after a shift in resonant frequency by the detuning effects, the detuned resonant frequency will be above the desired resonant frequency by an amount within the range of correction provided by bank 100. Fixed capacitors 136 and 138 are also chosen so that the combination of the fixed capacitors and the capacitance provided by bank 100 when a number of the switches of relay 101 are closed so that bank 100 effects a predetermined capacitance (for example, approximately 100pf) provides the total capacitance of $C_2$ (Figure 1B) equal to the value of $C_2$ as calculated above (*i.e.,* in matching the antenna's resonant frequency to the reader's operating frequency and in matching the antenna and reader impedances). That is, the calculated value of $C_2$ is allocated between the fixed capacitors and variable capacitor bank 100 under an assumption that variable capacitor bank 100 effects the predetermined capacitance. The selection of the predetermined capacitance of bank 100 at the initial factory calibration allows the capacitance to be increased or decreased depending on the direction of the shift in resonant frequency when the antenna is placed in the field. Thus, in the presently described embodiment, the total capacitance of bank 100 is sufficient to move the antenna resonant frequency at least the maximum expected detuning frequency shift. Typically, the shift in resonant frequency will occur within several megahertz of the desired operating frequency.

Still referring to Figure 7A, fixed capacitors 144 and 146 of impedance capacitance 152 are chosen in a similar manner. As described in more detail below, once the antenna's resonant frequency shifts due to environmental changes, the value of $C_2$ is adjusted to again match the antenna's resonant frequency to the reader's operating frequency. Because

the ratio of $C_1$ to $C_2$ determines the impedance match, the presently described embodiment adjusts $C_1$ to maintain the desired ratio and, therefore, the desired impedance match. $C_1$ is, in turn, defined by the combination of fixed capacitors 144 and 146 and the variable capacitance of capacitor bank 102. The initial value of $C_1$ as calculated above is allocated between the fixed capacitors and capacitor bank 102 with the assumption that a number of the switches of relay 103 are closed so that bank 102 effects a predetermined capacitance (for example, approximately 100pf). This predetermined capacitance is selected so that the capacitance of variable capacitor bank 102 may be increased or decreased as needed to account for the potential change in the capacitance of $C_2$ effected by variable capacitor bank 100. As should be understood by those skilled in this art, the initial capacitances for variable capacitor banks 100 and 102 may be selected through experimentation with a given antenna system within expected environmental conditions.

The values of the capacitors in each bank allow the capacitance of the respective bank to be varied from 0pF (assuming all associated relays are opened) to 255pF (assuming all associated relays are closed) by increments of 1pF depending on which relays are opened and closed. Therefore, the value of frequency capacitance 150 (see Figure 7B) can be varied from 690pF to 978pF, while impedance capacitance 152 can be varied from 1.470nF to 1.725nF in the present embodiment. As described in the algorithm below, at the beginning of a re-tuning sequence, the relays of capacitor banks 100 and 102 are all open. As each relay in switch 101 is closed, frequency capacitance 150 increases, causing the antenna's resonant frequency to decrease. As each relay of switch 103 are closed, impedance capacitance 152 increases. The manner by which the specific switches of the relays are opened and closed is described in more detail below with respect to the description of the controlling algorithm. As noted above, it should be understood that capacitors 136, 138, 144, and 146, as well as the capacitors in banks 100 and 102, may be removed or altered depending on the requirements of the associated antenna system, including desired operating frequency, expected detuning effects, retuning accuracy, and desired loaded Q. Further, additional capacitors may be added in parallel to those contained in banks 100 and 102 in order to increase the capacitance associated with each switch of relays 101 and 103.

In operation, and still referring to Figures 7A and 7B, microcontroller 48 (Figure 5) instructs the switches of relays 101 and 103 associated with each capacitor contained in respective variable capacitor banks 100 and 102 to open and close, thereby defining which capacitors contained in the respective bank become part of the tapped C transformer circuit. Each relay has an eight-bit shift register input that receives an eight-bit binary number that corresponds to a particular combination of open and closed switches. Thus, microcontroller 48 writes a value to the relay's eight-bit shift register, thereby determining which switches are opened or closed. For example, a binary value of 0 indicates that no switches are closed, whereas a value of 255 indicates that all switches are closed. Each bit in the eight bit binary number corresponds to the state of one of the eight switches in the relay. Accordingly, in the present embodiment, each binary value from 0 to 255 corresponds to an incremental increase in the capacitor bank's capacitance as determined by the open and closed switches. In other words, the value written to the register directly corresponds to the capacitance value of the respective capacitor bank in the present embodiment. In other embodiments incorporating capacitors in banks 100 and 102 exhibiting capacitances different from those illustrated in Figure 7A, each eight bit binary number accepted by registers 101 and 103 is related to a unique capacitance of the respective register defined by the summation of the capacitors associated with closed switches as indicated by the binary number. As the switch associated with each relay is instructed to close, the capacitor is essentially added to the circuit of tuning circuitry 54, whereas each capacitor is removed from the circuit when its associated switch is instructed to open. Therefore, microcontroller 48 is configured to alter variable capacitor banks 100 and 102 via respective relays 101 and 103, which alters frequency capacitance 150 and impedance capacitance 152, respectively. The sequence by which microcontroller 48 opens and closes the relays' switches associated with the capacitors in variable capacitor banks 100 and 102 is defined by the algorithm described below.

Referring to Figures 5, 6, and 7A, it should be apparent that relays 101 and 103 are electromechanical elements, which require some amount of time to operate. This is referred to as the relay's "settling time" and is approximately 0.5 milliseconds in the current embodiment. Accordingly, when a value is written to the register of either relay 101 or 103, microcontroller 48 must wait a period of at least equal to the settling time to allow the switches to open and close before attempting to read the antenna signal from the envelope detector. During this time, the microcontroller activates FET 95, allowing any charge on capacitor 96 or otherwise on the connection between SDAC 46 and ADC 50 of microcontroller 48 to pass to ground 80. Once the settling time has passed, the microcontroller deactivates instructs FET 95.

EMI filters 60 reduce and remove any electrostatic or radio noise between microcontroller 48 and the antenna reader.

Adjustment of the impedance through the tapped C transformer does not significantly affect the loaded Q. As noted above, detuning occurs because of changes in the environment of antenna 42, for example with regard to the ambient temperature and the presence of metal in the working environment. As the antenna's resonant frequency changes, the value of the antenna's inductive reactance may also change. As a result, the source and load impedances do not match at the resonant frequency. The antenna is preferably tuned so that the resonant frequency matches the desired frequency and the impedances of the antenna and reader match at the desired frequency. Specifically, the capacitance of tuning circuitry 54 is changed in order to retune the antenna and reacquire the impedance match. As noted above, the reactive components used in tuning circuitry 54, such as antenna 42 and the various capacitors, exhibit a high component Q, thereby having a minimal affect on the desired loaded Q. Thus, the use of capacitors to comprise tuning circuitry 54 allows selectivity of the capacitances of the tapped C transformer, to thereby change the resonant frequency and match the antenna to the reader at the desired frequency, without negatively affecting the desired loaded Q.

As described above, microcontroller 48 instructs relays 101 and 103 to open and close the switches contained therein based on a predefined algorithm in order to vary the capacitance of tuning circuitry 54 to thereby retune the antenna. The algorithm comprises two stages: coarse tuning and fine tuning. A detailed description of the algorithm follows with reference to Figures 8 through 12.

When the user actuates the microprocessor to begin the process, for example through depression of a button or a GUI connected to the reader when the antenna has been placed in the operating environment, and referring to Figure 8, the algorithm begins the first stage (coarse tuning) at step 200. Step 202 initializes three variables, referred to hereinafter as "PeakC1," "PeakC2," and "FinalPeak." Another variable, "Frequency Cap," is initialized to an eight bit binary value of 1 at step 204, which is then written to the register of relay 101 (Figure 7A) at step 208. In another embodiment, the Frequency Cap variable is initialized to an eight bit binary value of 0. As described above, writing a value to the register of relay 101 causes the switches associated with the binary number to open or close. In this case, the binary value of 1 causes the switch associated with capacitor 104 to close and the switches associated with capacitors 106-118 to open, resulting in a capacitance of 1pF for bank 100. Therefore, the capacitance of frequency capacitance 150 (Figure 7B) in the present embodiment, which is defined by the summation of the capacitances of bank 100 and capacitors 136 and 138 because they are connected in parallel, is 691pF. As described above for the present embodiment, each incremental increase in the binary value written to the register of relay 101 increases the capacitance of bank 100 and, thus, frequency capacitance 150, by a capacitance of 1pF.

Another variable, "Match Cap," is initialized to 1(or, in another preferred embodiment, 0) at step 210 and then written to the register of relay 103 at step 214. Writing a binary value of 1 to the register of relay 103 causes the switch associated with capacitor 120 to close and the switches associated with capacitors 122-134 to open, resulting in a capacitance of 1pF for bank 102. Therefore, the capacitance of impedance capacitance 152 (Figure 7B), which is defined by the summation of the capacitances of bank 102 and capacitors 144 and 146, is 1.471 nF. Similar to the values written to the register of relay 100, each incremental increase in the binary value written to the register of relay 103 increases the capacitance of bank 102 and, thus, impedance capacitance 152, by a capacitance of 1 pF. As noted above, it should be understood that the capacitors contained in banks 100 and 102 may be removed or altered to exhibit other desirable capacitances. Accordingly, each binary number instructs relays 101 and 103 to close and open the switches associated with the capacitors contained in banks 100 and 102, thereby defining the banks' capacitances. Theses capacitances, however, can be configured to exhibit the desired range of capacitance depending on the configuration and use of the associated antenna system. For example, in another preferred embodiment, each capacitor contained in bank 102 exhibits twice the capacitance of the corresponding capacitor contained in bank 100, thereby providing a relatively larger capacitance range for bank 102.

As set forth below, the values of the Frequency Cap and Match Cap variables are periodically written to the registers of relays 101 and 103, respectively, thereby defining which switches of the respective relays are open and closed. The capacitances of banks 100 and 102 are defined by the capacitors associated with the closed relays. Because the capacitance of frequency capacitance 150 and impedance capacitance include the capacitances of banks 100 and 102, respectively, the values of the Frequency Cap and Match Cap variables directly affect the capacitance of the frequency capacitance and impedance capacitance, respectively.

As noted above, a settling time to open and close the relevant switches is required by relays 101 and 103 once a value has been written to the relays' register and prior to sampling the signal transmitted by the antenna. In the present embodiment, this settling time is 0.5 milliseconds, during which the antenna system waits. This is done each time a value is written to relay 101 and/or relay 103. Once the settling time has passed, process flow continues.

At step 216, the signal transmitted by the antenna is measured and converted to a numeric value directly corresponding to the power level of the signal transmitted by the antenna in the manner described above with respect to Figures 5, 6, 7A, and 7B. This value is compared to the value of the FinalPeak variable at step 218 and, if it exceeds the previous value, is stored in the FinalPeak variable. Because the value of the FinalPeak variable is initially set to 0, the current numeric value corresponding to the first signal transmitted by the antenna during the tuning process is stored in the FinalPeak variable. Each time a value is created from measuring the signal transmitted by the antenna, it is compared with the value of the FinalPeak variable. If the created value is greater than the value of the FinalPeak variable, the created value replaces the value of the FinalPeak variable and is stored therein. The FinalPeak variable will therefore contain a numeric value that corresponds to the signal transmitted by the antenna and measured by the antenna system exhibiting the greatest power level. If this happens, the PeakC1 variable is set to the current value of the Frequency Cap variable, and the PeakC2 variable is set to the current value of the Match Cap variable. In the present embodiment, the PeakC1 and PeakC2 variables will thus contain the capacitance value of variable capacitor banks 100 and 102, respectively, that produced the signal exhibiting the maximum power as represented by the value of the FinalPeak variable.

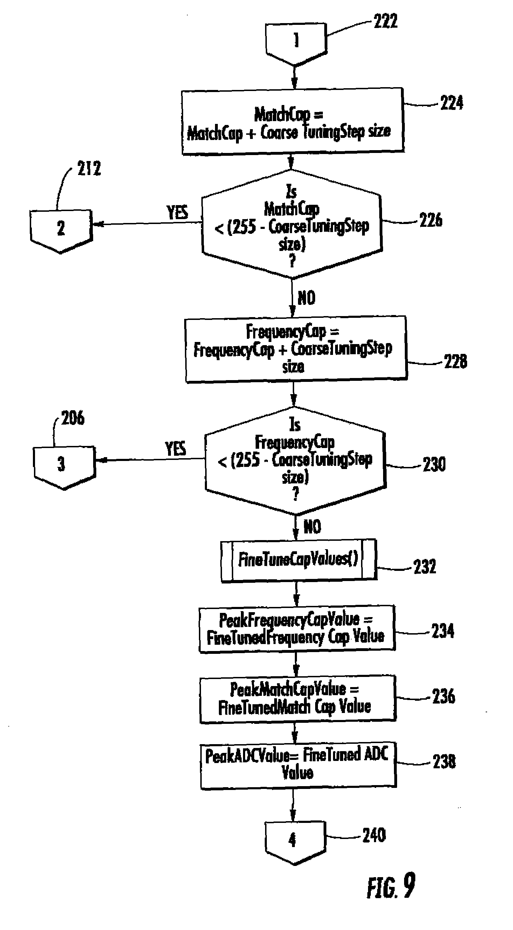

Process flow then continues to step 224 (Figure 9). If the current numeric value is not greater than the value of the FinalPeak variable, process flow continues directly to step 224.

In a preferred embodiment as described above, step 216 is performed twenty times, so that the signal transmitted by the antenna, corresponding to the current settings of banks 100 and 102, is measured twenty times, resulting in twenty numeric values. The twenty values for the current settings are summed and averaged to provide one numeric value. The average (instead of the current numeric value) is then compared to the value of the FinalPeak variable. The process is otherwise identical to that described above.

Referring to Figure 9, the Match Cap variable is incremented by a predefined coarse tuning amount, which is set to 2 in the present embodiment and corresponds to an increase in 2 pF of the applicable capacitor bank. At step 226, the incremented Match Cap variable is compared to the maximum allowable register value of relay 103 (Figure 7A), *i.e.,* 255. If Match Cap is less than 255, process flow follows path 212 to step 214, where the incremented Match Cap value is written to the register of relay 103. As explained above, the value of the Match Cap variable written to the register of relay 103 both defines which switches of the relay are open and closed and equals the capacitance of associated bank 102. At step 216, the signal transmitted by the antenna is again sampled and converted to a numeric value. Process flow continues again to step 220, as needed, and to step 224. The process consisting of steps 224, 226, 214, 216, 218, and 220 is an iterative process and continues until Match Cap exceeds 255, at which point process flow continues to step 228.

At step 228, the Frequency Cap variable is incremented by a predefined coarse tuning amount, which is also set to 2 in the present embodiment. At step 230, the incremented Frequency Cap is compared to the maximum allowable register value of relay 101 (Figure 7A), *i.e.,* also 255. If Frequency Cap is less than 255, process flow follows path 206 to step 208, where the incremented Frequency Cap value is written to the register of relay 101. As explained above, the value of the Frequency Cap variable written to the register of relay 101 both defines which switches of the relay are open and closed and equals the capacitance of associated bank 100. At step 210, Match Cap is initialized back to 1 and written to the register of relay 103 at step 214. Process flow proceeds to step 216 and performs the iterative process described above with respect to the Match Cap variable until the signal transmitted by the antenna has been measured for all capacitance values of Match Cap (variable capacitor bank 102) incremented by the coarse tuning amount for the current value of Frequency Cap (variable capacitor bank 100). For example, when the value of the Frequency Cap variable is incremented from 1 to 3, a binary number equivalent to 3 is written to the register of relay 101, which directs the switches associated with capacitors 104 and 106 to close and the switches associated with capacitors 108-118 to open. As a result, the capacitance of bank 100 is defined by the capacitance of the capacitors associated with closed switches. In this case, capacitors 104 and 106 are associated with closed switches and have a capacitance of 1 pF and 2 pF, respectively, in the present embodiment. Accordingly, the capacitance of bank 100 is 3 pF, which is also the current value of the Frequency Cap variable. The value of the Match Cap variable is sequentially incremented from 1 to 255 by the coarse tuning amount. Each incremented value of the Match Cap variable is written to the register of relay 103. As a result, the capacitance of bank 100, which is defined by the capacitors associated with closed switches as determined by the value of the Match Cap variable, varies from 1 to 255 in the present embodiment by steps of the coarse tuning amount. Thus, while the capacitance of bank 100 is 3 pF, the capacitance of bank 102 is varied by an amount equal to the coarse tuning amount from 1 to 255. For each capacitance value of bank 102, the signal transmitted by the antenna is measured and converted to a numeric value as described above. The values and range of capacitances of banks 100 and 102 may be changed depending on the capacitors contained in each bank in other embodiments as noted above.

Process flow continues again to step 228 where the Frequency Cap variable is incremented again by the coarse tuning amount. It should be understood that the above process measures the transmitted signal for all the coarse tuning increases in variable capacitor bank 102 for each coarse tuning increase in variable capacitor bank 100. Accordingly, the maximum value created by ADC 50 (Figure 5) during this process is stored in the variable FinalPeak, and the values of Frequency Cap and Match Cap variables associated with the maximum value from the ADC stored in the FinalPeak variable are stored in PeakC1 and PeakC2, respectively.

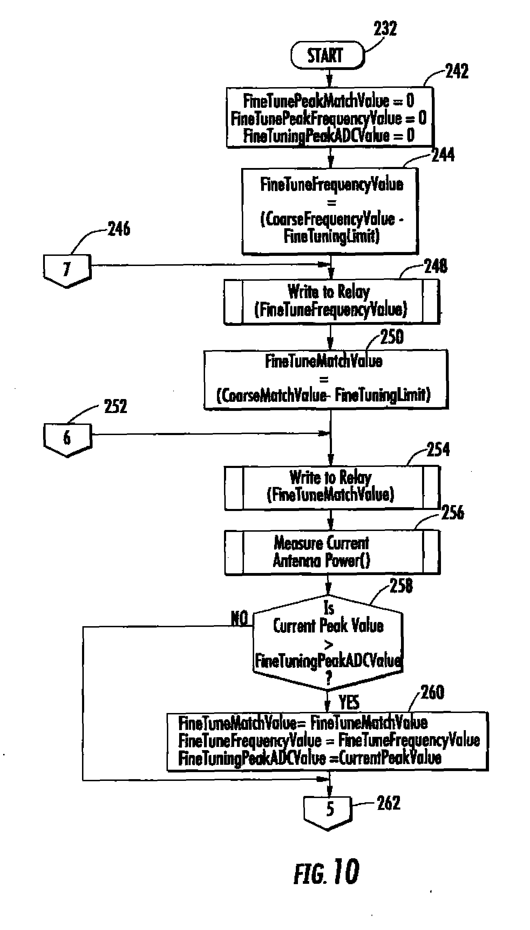

When the value of the Frequency Cap variable exceeds 255, process flow then continues to step 232 where the second stage (fine tuning) begins. Referring to Figure 10, three variables are initialized at step 242, referred to hereinafter as "FineTunePeakMatchValue" (or "Match Peak" for simplicity), "FineTunePeakFrequencyValue" (or "Frequency Peak"), and "FineTuningPeakADCValue" (or "Peak"). At step 244 another variable, "FineTuneFrequencyValue" (or "FT Frequency Cap"), is initialized to a value equaling a fine tuning limit subtracted from the value of the PeakC1 variable, which is equal to the value of variable capacitor bank 100 corresponding to the maximum value calculated by the ADC during the coarse tuning stage. In the present embodiment, the fine tuning limit is set to 20, which equals the number of variations that will be made to the capacitance of bank 100 above and below the value of the PeakC1 variable and corresponds to the number of variations that will be made to the capacitance of bank 100 during the fine tuning stage as set forth below. That is, the capacitance of bank 100 will be varied forty times from a capacitance 20 pF less than the value of PeakC1 to a capacitance of 20 pF greater than the value of PeakC1. Accordingly, this limit establishes the range of capacitance for bank 100 corresponding to the signal measured from antenna 42 (Figure 7A) during the fine tuning stage. The value of the FT Frequency Cap variable is then written to the register of relay 101 at step 248.

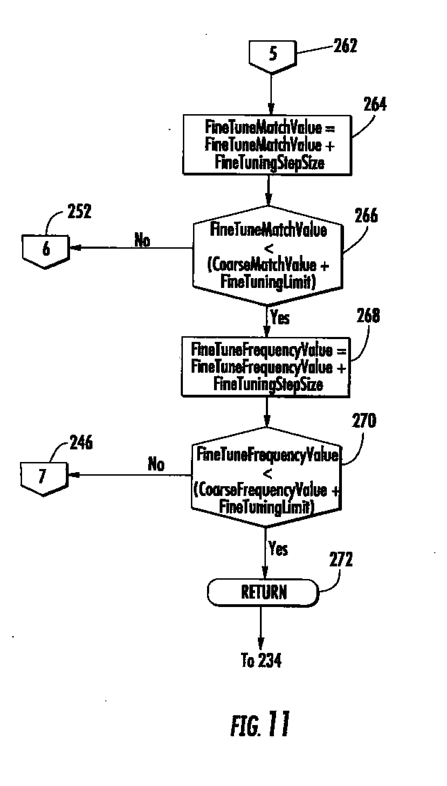

At step 250, a "FineTuneMatchValue" (or "FT Match Cap") variable is initialized to a value equaling the fine tuning limit subtracted from the value of the PeakC2 variable, which is equal to the value of variable capacitor bank 102 corresponding to the maximum value received from the ADC during the coarse tuning stage. Similar to the effect on frequency capacitance 150 (Figure 7B), the fine tuning limit establishes the capacitance range for bank 102, as well as the number of variations that will be made to the impedance capacitance for each capacitance variation of bank 100. The microcontroller writes the value of the FT Match Cap to the register of relay 103 at step 254. The signal transmitted from the antenna is analyzed and converted to a value at step 256 as described above. This value is compared to the value of the Peak variable at step 258, and if greater than the value of the Peak variable, it is stored in the Peak variable at step 260. Additionally at step 260, the current capacitance values stored in the FT Frequency Cap and FT Match Cap variables are stored in the Frequency Peak and Match Peak variables, respectively. Accordingly, the numeric value associated with the signal transmitted by the antenna exhibiting the greatest level of power is stored in the Peak variable, while the values of variable capacitor banks 100 and 102 that produced that signal are stored in the Frequency Peak and Match Peak variables, respectively, similar to the process described above with respect to the coarse tuning stage. Process flow then continues via path 262 to step 264 (Figure 11). If the value created by the ADC is not greater than the value of the Peak variable, process flow bypasses step 260 and continues via path 262 to step 264 (Figure 11).

Referring to Figure 11, the FT Match Cap variable is incremented by the value stored in a "FineTuningStepSize" variable at step 264. In the present embodiment, the value of FineTuningStepSize is 1, which equates to a 1 pF increase in the capacitance of bank 102 (Figure 7A). At step 266, the value of the FT Match Cap variable is compared to the sum of the fine tuning limit and PeakC2 in order to determine if the signal transmitted by the antenna has been measured for the entire range of values for bank 102 for each value of bank 100 to be used in the fine tuning stage. If it has not, process flow follows path 252 where steps 254, 256, 258, and 260 (if applicable) of Figure 10 are performed before the FT Match Cap is again incremented at step 264. Otherwise, process flow continues to step 268 where the FT Frequency Cap is incremented by the value of the FineTuningStepSize variable.

At step 270, the incremented FT Frequency Cap value is compared to the sum of the fine tuning limit and PeakC1 in order to determine if the signal transmitted by the antenna has been measured for the entire range of capacitance values for bank 100 (Figure 7A) to be used in the fine tuning stage. If it has not, process flow follows path 246 where steps 248 and 250, as well as the steps involving variation of the capacitance of bank 102 (Figure 7A) described above, are processed before the FT Frequency Cap is incremented again at step 268. Otherwise, the fine tuning stage is complete at 272, and process flow is returned to step 234 (Figure 9).

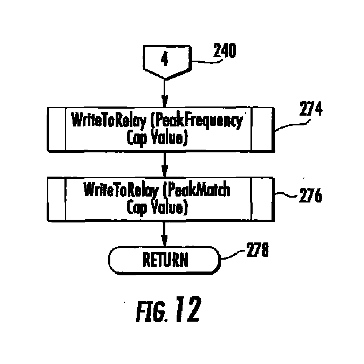

Referring to Figures 9 and 12, at steps 234 and 236, the value of variables "PeakFrequencyCapValue" and "PeakMatchCapValue" are set to equal the value of variables Frequency Peak and Match Peak, respectively. At step 238, the value of a "PeakADCValue" variable is set to equal the value of the Peak variable. Process flow then continues via path 240 to step 274 where the value of the PeakFrequencyCapValue is written to the register of relay 101, and at step 276, the value of the PeakMatchCapValue is written to the register of relay 103. The algorithm is complete at 278. Accordingly, the values stored in the PeakFrequencyCapValue and the PeakMatchCapValue variables after completion of the fine tuning stage and written to the registers are the capacitances of respective banks 100 and 102 that provide the maximum power output by the antenna system at the desired operating frequency. The capacitances of banks 100 and 102 comprise respective portions of frequency capacitance 150 and impedance capacitance 152, and, along with the fixed capacitances, define the capacitance of the tapped C transformer. As set forth above, this capacitance of the tapped C transformer matches both the antenna's resonant frequency to the desired operating frequency and the antenna impedance and to the reader impedance at the resonant frequency.

One of ordinary skill in the art should understand that the values by which frequency capacitance 150 and impedance capacitance 152 are incremented during the coarse and fine tuning stages of the above algorithm may be varied and/or other stages of tuning may be added to the above algorithm without departing from the scope and spirit of the present invention. Moreover, additional tuning iterations, such as performing the fine tuning stage for all values of the frequency and impendence capacitances, are included within the scope of the present invention. It should be understood that such variations allow for an exchange in the degree of fine tuning with an increase in speed, and vice versa, depending on the application of the present invention.

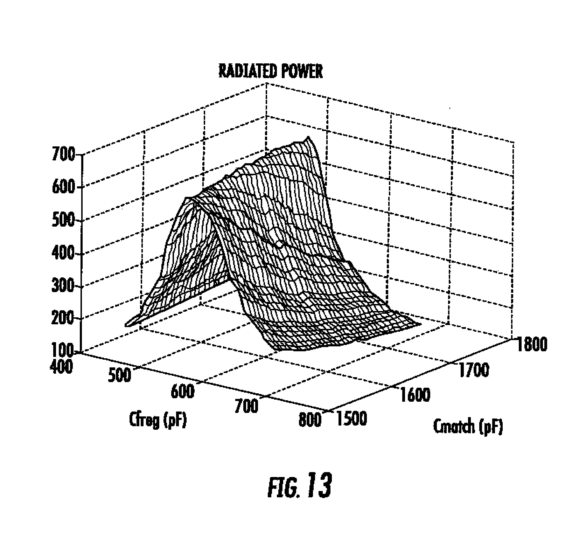

Figure 13 is a graphical illustration of the power radiated by an exemplary antenna system as measured and calculated by the process described above. The X axis, labeled "Cfreq (pF)," corresponds to the values of frequency capacitance 150 (Figure 7B), while the Y axis, labeled "Cmatch (pF)," corresponds to the values of impedance capacitance (Figure 7B) in the present embodiment. Therefore, the X axis and the Y axis directly correspond to the values written to the respective registers of relays 101 and 103 associated with variable capacitor banks 100 and 102 in the present embodiment. Each point on the graph illustrated in Figure 13 represents the numeric value created by ADC 50 (Figure 5) corresponding to the signal transmitted by antenna system 40 for a specific combination of the frequency and impedance capacitance values. These points represent the measurements and values received during the tuning process from ADC 50 (Figure 5) corresponding to the power output by antenna 42.

Referring to Figures 7A and 7B, it should be understood that the capacitors contained in banks 100 and 102 associated with relays 101 and 103 may be replaced by capacitors of other values depending on the desired use and operation, as well as the configuration, of antenna system 40. That is, the capacitors contained in the banks may be adjusted to alter the desired capacitance range of the tapped C transformer depending on certain factors, such as the source and load impedances and the desired operating frequency. For example, the capacitors in bank 102 may be replaced by capacitors that sequentially change in capacitance by increasing amounts, for example doubling or tripling, so that bank 102 may exhibit a broader capacitance range. It should also be noted that the number of capacitors contained in each bank or the number of capacitors that are selectively connected pursuant to above the algorithm may also be altered depending on certain factors, such as the desired tuning resolution or the time available to tune the antenna, without departing from the scope and spirit of the present invention.

Still referring to Figures 7A and 7B, and as described above, it should also be understood that impedance capacitance 152 does not affect the resonant frequency to the same degree as frequency capacitance 150. Furthermore, in the presently described embodiment, the change in frequency capacitance 150 needed to rematch the antenna's resonant frequency to the reader's operating frequency generally does not degrade the impedance match at the resonant frequency beyond an acceptable rage. In other words, the impedance capacitance provides negligible assistance in adjusting the resonant frequency, and the degradation in impedance match once the resonant frequency has been restored to the desired operating frequency is within an acceptable range. Accordingly, in another preferred embodiment, the impedance capacitance is a fixed value.

In this embodiment, variable capacitor bank 102 is omitted from tuning circuit 54 or, if present, disabled, dismounted, or configured so that all associated switches are preset and not varied in the above described algorithm. Thus, and assuming that capacitor bank 102 is omitted or dismounted, impedance capacitance 152 is equal to the sum of the capacitance values of capacitors 144 and 146 only; that is, 1.470 pF. Removal or nonuse of variable capacitor bank 102 reduces the amount of time required to perform the algorithm described above, in that the steps of the algorithm directed to calculating, comparing, and changing the capacitance value of variable capacitor bank 102 are unnecessary and are therefore omitted. For example, in the coarse tuning stage, for each change in the value of variable capacitor bank 100, microcontroller 48 makes approximately 125 changes to the register of relay 103 associated with variable capacitor bank 102. Each time the register of relay 103 is changed, the settling time of the relay is accommodated, twenty measurements of the corresponding signal are taken, and the resulting value is compared to previous values. As a result, the signal transmitted by the antenna is sampled, measured, and converted to a numeric value approximately 2500 times. Since approximately 125 changes are made to the register associated with variable capacitor bank 100, over 30,000 measurements of the transmitted signal are eliminated when variable capacitor bank 102 is not used during the coarse tuning stage alone.

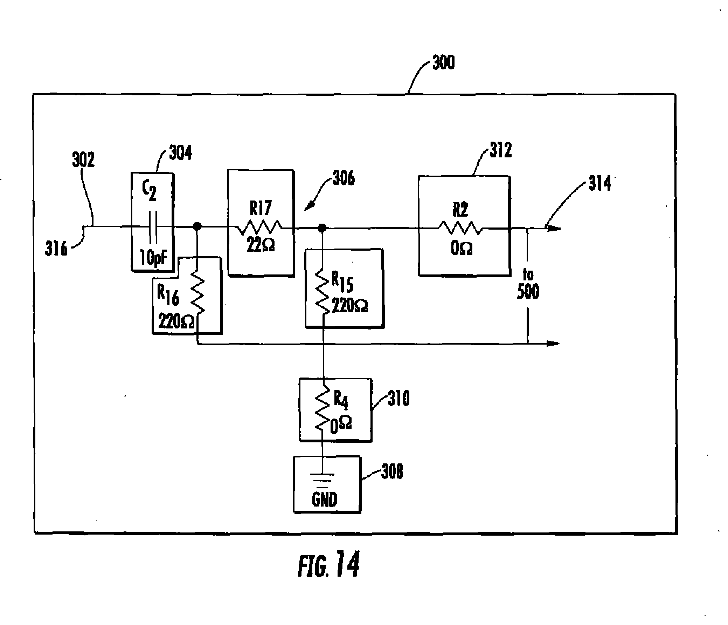

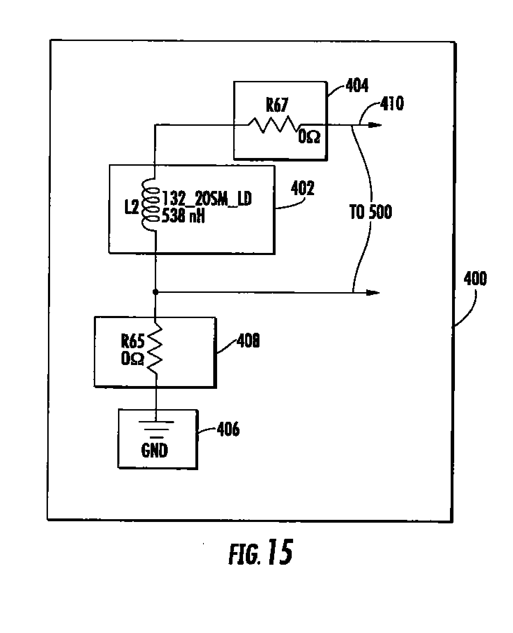

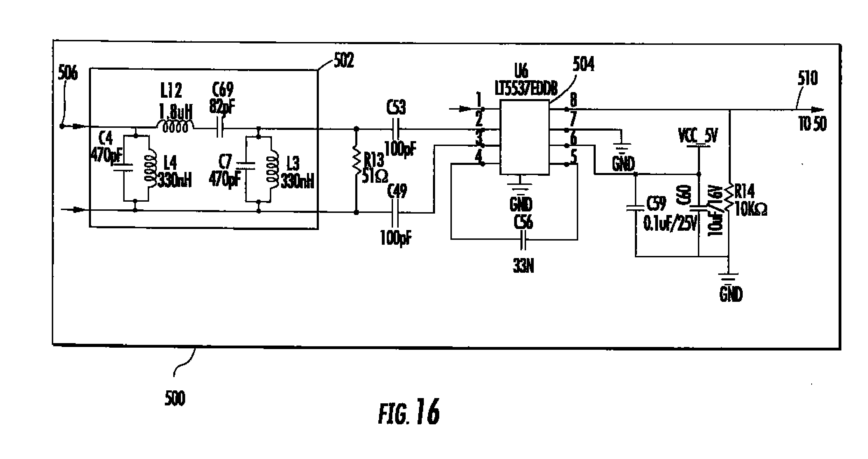

As described above with respect to Figure 5, coupling 66 may be effected by any means suitable to provide sampling circuit 44 with a signal representative of the magnetic field the antenna radiates in response to the drive signal, such as inductive coupling or through a jumper wire that directly connects the electrical current in the antenna to the sampling circuit. In another embodiment as shown in Figure 14, sampling circuit 44 (Figure 5) comprises a feedback circuit 300 that connects to antenna 42 (Figure 5) by a jumper wire (indicated at 302). In another embodiment illustrated in Figure 15, sampling circuit 44 comprises a probe circuit 400 that receives the magnetic signal radiated by antenna 42 (Figure 5) by inductive coupling. In these embodiments, SDAC 46 of Figure 5 comprises a conditioning circuit 500 (Figure 16) that receives an AC signal from either feedback circuit 300 or probe circuit 400, converts the AC signal to a DC signal, and transmits the signal to ADC 50 (Figure 5), as described in more detail below.

Referring to Figure 14, feedback circuit 300 comprises a capacitor 304 and a voltage divider network 306, which is connected to ground 308 through a resistor 310. In operation, a jumper is physically connected to antenna 42 (Figure 5) at point 316 so that the AC signal tapped from the jumper through capacitor 304 is output through voltage divider network 306, which reduces the signal at a constant impedance, to conditioning circuit 500 (Figure 16) through a resistor 312 at point 314.

Referring to Figure 15, probe circuit 400 comprises a probe antenna 402 connected to a resistor 404 on one side and to ground 406 through a resistor 408 on the other. Probe circuit 400 is not a high Q circuit in order to prevent negative effects on the tuning process. In operation, probe antenna 402 is placed near antenna 42 (Figure 5) so that it receives the magnetic signal radiated by antenna 42 and outputs the signal to conditioning circuit 500 (Figure 16) through resistor 404 at point 410. The amount of coupling depends on the geometric dimensions of probe antenna 402 and antenna 42 (Figure 5) and their relative positions.

Referring to Figure 16, conditioning circuit 500 comprises a band pass filter 502 connected to a log detector 504. In operation, conditioning circuit 500 receives the signal at point 506 that is output by feedback circuit 300 (Figure 14) at point 314 or by probe circuit 400 (Figure 15) at point 410. The signal is passed through band pass filter 502, which passes signals at the desired operating frequency to log detector 504. Log detector 504 converts the signal received to a DC signal at a logarithmic scale, which is output to ADC 50 (Figure 5) at point 510. It should be understood that log detector 504 is operated as a single-ended detector.

Referring to Figures 5, 14, 15, and 16, feedback circuit 300 and probe circuit 400 are examples of sampling circuit 44, and either can be used with conditioning circuit 500, which is an example of SDAC 46, to comprise a sensor circuit in communication with antenna 42 that detects a response by the antenna to the drive signal and outputs a signal to microcontroller 48 corresponding to the power of the magnetic field radiated by the antenna in response to the drive signal.

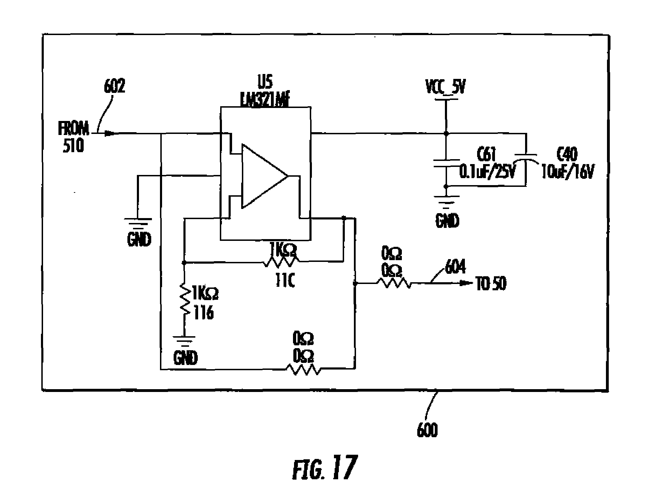

Figure 17 illustrates an optional buffer circuit 600 used in combination with conditioning circuit 500 (Figure 16) in accordance with another embodiment of the present invention. In operation, buffer circuit 600 receives the DC signal at point 602 that is output by conditioning circuit 500 (Figure 16) at point 510 and outputs the DC signal to ADC 50 (Figure 5) at point 604. Buffer circuit 600 essentially defines a unity gain, although the circuit could be configured to change the gain of the DC signal received at point 602 to drive the output signal at point 604. Specifically, buffer circuit 600 exhibits a low output impedance and a relatively high input impedance.

While one or more preferred embodiments of the invention have been described above, it should be understood that any and all equivalent realizations of the present invention are included within the scope and spirit thereof. The embodiments depicted are presented by way of example only and are not intended as limitations upon the present invention. Thus, it should be understood by those of ordinary skill in this art that the present invention is not limited to these embodiments since modifications can be made. Therefore, it is contemplated that any and all such embodiments are included in the present invention as may fall within the scope and spirit thereof.

According to the invention, a radio frequency identification tag reader system may comprise:

a radio frequency identification tag reader that outputs a drive signal at a predetermined frequency at which a radio frequency tag operates;
an antenna that receives the drive signal and radiates an electromagnetic field in response to the drive signal;
a tuning circuit disposed between the reader and the antenna so that the drive signal passes through the tuning circuit, wherein the tuning circuit has at least one component that defines a selectable, variable electrical characteristic that selects a resonant frequency of the antenna;
a sensor circuit in communication with the antenna so that the sensor circuit detects a response by the antenna to the drive signal and outputs a sensor signal that corresponds to power of an electromagnetic field radiated by the antenna in response to the drive signal; and
a processor in communication with the tuning circuit so that the processor controls the selectable component, and wherein the processor receives the sensor signal and sets the variable electrical characteristic in response to the sensor signal.

The sensor circuit may couple to the antenna through a capacitance. The sensor circuit may include an alternating current to direct current converter that is configured to output a direct current signal to the processor. Alternatively the sensor circuit may inductively couple to the antenna.

The sensor circuit may comprise a secondary antenna that inductively couples to the antenna. The tuning circuit may comprise a capacitive transformer comprising a first capacitance in series between the reader and the antenna and a second capacitance in parallel between the reader and the antenna. The first capacitance may be variable, and the processor may be in communication with the first capacitance so that the processor controls the variable first capacitance. The processor may alter the variable first capacitance over a first range of predetermined capacitance values. The second capacitance may variable, and the processor may be in communication with the second capacitance so that the processor controls the variable second capacitance. The processor may alter the variable second capacitance over a second range of predetermined capacitance values.

According to the invention, a method for tuning an antenna system may comprise the following steps:

a. applying a drive signal to an antenna through a tuning circuit, wherein the tuning circuit has at least one component that defines a selectable, variable electrical characteristic that selects a resonant frequency of the antenna;
b. receiving a first response signal corresponding to a first electromagnetic field radiated by the antenna in response to a first setting of the variable electrical characteristic;
c. varying the variable electrical characteristic to a second setting by a predetermined increment;
d. repeating steps (a) through (c) for a range of predefined values for the variable electrical characteristic, wherein each said second setting of a step (c) is the first setting of a next step (b);
e. selecting a first response signal from among a plurality of first response signals received at the steps (b) according to a predetermined criteria; and
f. selecting the first setting of the variable electrical characteristic at which the selected first response signal was received.

The selecting at step (e) may be performed electronically. The selecting at step (f) may be performed electronically.

According to the invention, there is provided a method of tuning a radio frequency identification tag reader system having a radio frequency identification tag reader that outputs a drive signal at a predetermined frequency at which a radio frequency tag operates, an antenna that receives the drive signal and radiates an electromagnetic field in response to the drive signal, and a tuning circuit disposed between the reader and the antenna so that the drive signal passes through the tuning circuit, wherein the tuning circuit has at least one component that defines a selectable, variable capacitance between the reader and the antenna, comprising:

  a. detecting a response by the antenna to the drive signal at a selected setting of the variable capacitance;
  b. measuring power of the response and generating a signal corresponding to the power;
  c. altering the setting of the variable capacitance;
  d. repeating steps (a) through (c) over a range of settings of the variable capacitance;
  e. electronically comparing the signals corresponding to the power at said settings over the range of settings of the variable capacitance;
  f. electronically selecting the setting at which a highest power at step (e) occurs; and
  g. electronically adjusting the selectable, variable capacitance to the setting selected at step f.

The altering at step (c) may include altering the setting of the variable capacitance by a predetermined increment. The step (e) may comprise comparing, at step (c), the measured power of the response signal from step (b) to a reference power and storing the measured power if the measured power is greater than the reference power. The range of settings of the variable capacitance may be predetermined.

## Claims

1. An antenna system (40), comprising:

  an antenna (42) that radiates an electromagnetic field in response to a drive signal supplied by a reader (56, 64);
  a tuning circuit (54) connected to the antenna through which the drive signal passes, wherein the tuning circuit has at least one component that defines a selectable, variable resonant frequency of the antenna;
  a sensor circuit (44, 46, 300, 400, 500, 600) in communication with the antenna so that the sensor circuit receives a response signal corresponding to the electromagnetic field and outputs a sensor signal that corresponds to the response signal; and
  a processor (48) in communication with the tuning circuit so that the processor controls the selectable component, and wherein the processor receives the sensor signal and sets the variable resonant frequency through the selectable component in response to the sensor signal.

2. The antenna system of claim 1 wherein the sensor circuit couples to the antenna through a capacitance.

3. The antenna system of claim 1 where the sensor circuit includes an alternating current to direct current converter that is configured to output a direct signal to the processor.

4. The antenna system of claim 1 wherein the sensor circuit inductively couples to the antenna.

5. The antenna system of claim 4 wherein the sensor circuit comprises a secondary antenna (402) that inductively couples to the antenna.

6. The antenna system of claim 1 wherein the tuning circuit comprises a capacitive transformer (11) comprising a first capacitance (100, 136, 138) in series between the reader and the antenna and a second capacitance (102, 144, 146) between the reader and an antenna ground.

7. The antenna system of claim 6 wherein the first capacitance is variable, and wherein the processor is in communication with the first capacitance so that the processor controls the variable first capacitance.

8. The antenna system of claim 7 wherein the processor alters the variable first capacitance over a range of predetermined capacitance values.

9. The antenna system of claim 6 wherein the second capacitance is variable, and wherein the processor is in communication with the second capacitance so that the processor controls the variable second capacitance.

10. The antenna system of claim 9 wherein the processor alters the variable second capacitance over a range of predetermined capacitance values.

11. A method for tuning an antenna system (40) comprising the following steps:

a. applying a drive signal to an antenna (42) through a tuning circuit (54), wherein the tuning circuit has at least one component that defines a selectable, variable resonant frequency of the antenna;
b. receiving a first response signal corresponding to a first electromagnetic field radiated by the antenna in response to a first setting of the variable resonant frequency;
c. varying the variable resonant frequency to a second setting;
d. repeating steps (a) through (c), wherein each said second setting of a step (c) is the first setting of a next step (b); and
e. electronically selecting a first response signal from among a plurality of first response signals received at the steps (b) according to a predetermined criteria and electronically selecting the first setting of the variable resonant frequency at which the selected first response signal was received.

12. The method of claim 11 wherein the varying at step (c) includes varying the second setting of the variable resonant frequency by a predetermined increment.

13. The method of claim 12 wherein the repeating at step (d) is repeated for a range of predefined values for the variable resonant frequency.

14. The method of claim 13 wherein the range of predefined values for the variable resonant frequency is predetermined.

FIG. 1A

FIG. 1B

EP 2 051 185 A1

**1 ACTIVE CH/TRACE    2 RESPONSE   3 STIMULUS   4 Mkr/ANALYSIS   5 Instr STATE**

▷ TR1 S11 Log Mag 5.000dB/ Ref 0.000dB

| | SYSTEM |
| | △ |
| | PRINTER SETUP |
| | INVERT MAGE ON |
| | DUMP SCREEN IMAGE |
| | 87075 SETUP ▷ |
| | MISC SETUP ▷ |
| | BACKLIGHT ON |
| | FIRMWARE REVISION |
| | SERVICE MENU ▷ |
| | RETURN |
| | ▽ |

CENTER 13.56 MHz          IFBW 30 kHz          Span 5 MHz OFF

Meas  STOP  ExtRef  Svc  2007-06-25 09:11

**FIG. 2**

FIG. 3

FIG. 4

FIG. 5

*FIG. 6*

EP 2 051 185 A1

FIG. 7A

26

FIG. 7b

FIG. 8

FIG. 9

START —232

FineTunePeakMatchValue = 0
FineTunePeakFrequencyValue = 0
FineTuningPeakADCValue = 0 —242

FineTuneFrequencyValue
=
(CoarseFrequencyValue -
FineTuningLimit) —244

7 —246

Write to Relay
(FineTuneFrequencyValue) —248

FineTuneMatchValue
=
(CoarseMatchValue- FineTuningLimit) —250

6 —252

Write to Relay
(FineTuneMatchValue) —254

Measure Current
Antenna Power() —256

Is
Current Peak Value
>
FineTuningPeakADCValue
? —258

NO

YES

FineTuneMatchValue= FineTuneMatchValue
FineTuneFrequencyValue = FineTuneFrequencyValue
FineTuningPeakADCValue =CurrentPeakValue —260

5 —262

FIG. 10

5 — 262

FineTuneMatchValue =
FineTuneMatchValue +
FineTuningStepSize — 264

252

6 ← No — FineTuneMatchValue
<
(CoarseMatchValue +
FineTuningLimit) — 266

Yes

FineTuneFrequencyValue =
FineTuneFrequencyValue +
FineTuningStepSize — 268

246

7 ← No — FineTuneFrequencyValue
<
(CoarseFrequencyValue +
FineTuningLimit) — 270

Yes

RETURN — 272

To 234

FIG. 11

FIG. 12

FIG. 13

FIG. 14

FIG. 15

FIG. 16

EP 2 051 185 A1

FIG. 17

37

Europäisches
Patentamt

European
Patent Office

Office européen
des brevets

**EUROPEAN SEARCH REPORT**

Application Number

EP 08 16 6671

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | WO 2006/054070 A (INNOVISION RES & TECH PLC [GB]; KEEN IAN [GB]; SYMONS PETER [GB]; HUOM) 26 May 2006 (2006-05-26) * abstract * * page 2, line 24 - line 28 * * page 4, line 20 - line 26 * * page 5, line 6 - line 7 * * page 7, line 11 - line 19 * * page 11, line 12 - line 18 * * page 17, line 13 - page 18, line 3 * * figures 1,3 * | 1-14 | INV. G06K7/00 H01Q1/00 H03J1/00 H04B5/00 |
| X | GB 2 419 777 A (HEWLETT PACKARD DEVELOPMENT CO [US]) 3 May 2006 (2006-05-03) * page 7, line 1 - line 7 * * page 7, line 20 - line 28 * * page 8, line 4 - line 13 * * page 8, line 20 - line 24 * * figure 2 * | 1-14 | |
| X | US 6 903 656 B1 (LEE DONNY V [US]) 7 June 2005 (2005-06-07) * column 6, line 46 - column 8, line 24 * * figure 2 * | 1-14 | TECHNICAL FIELDS SEARCHED (IPC) G06K |
| X | US 6 317 027 B1 (WATKINS RANDY [US]) 13 November 2001 (2001-11-13) * column 2, line 25 - line 47 * * column 3, line 6 - column 4, line 39 * * figure 1 * | 1-14 | |

The present search report has been drawn up for all claims

| Place of search | Date of completion of the search | Examiner |
|---|---|---|
| The Hague | 29 January 2009 | Al-Hazam, Lorens |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 08 16 6671

This annex lists the patent family members relating to the patent documents cited in the above-mentioned European search report.
The members are as contained in the European Patent Office EDP file on
The European Patent Office is in no way liable for these particulars which are merely given for the purpose of information.

29-01-2009

| Patent document cited in search report | | Publication date | Patent family member(s) | | Publication date |
|---|---|---|---|---|---|
| WO 2006054070 | A | 26-05-2006 | EP | 1815608 A1 | 08-08-2007 |
| | | | GB | 2436227 A | 19-09-2007 |
| | | | US | 2008194200 A1 | 14-08-2008 |
| GB 2419777 | A | 03-05-2006 | WO | 2006045817 A2 | 04-05-2006 |
| | | | US | 2009002175 A1 | 01-01-2009 |
| US 6903656 | B1 | 07-06-2005 | NONE | | |
| US 6317027 | B1 | 13-11-2001 | AT | 356393 T | 15-03-2007 |
| | | | AU | 758293 B2 | 20-03-2003 |
| | | | AU | 2404700 A | 01-08-2000 |
| | | | CA | 2360298 A1 | 20-07-2000 |
| | | | CN | 1367915 A | 04-09-2002 |
| | | | CN | 1696956 A | 16-11-2005 |
| | | | DE | 60033785 T2 | 08-11-2007 |
| | | | EP | 1145203 A1 | 17-10-2001 |
| | | | ES | 2283286 T3 | 01-11-2007 |
| | | | HK | 1048551 A1 | 01-09-2006 |
| | | | JP | 2002535860 T | 22-10-2002 |
| | | | WO | 0042585 A1 | 20-07-2000 |
| | | | ZA | 200106429 A | 10-09-2002 |

**EP 2 051 185 A1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 773634 P